(19) Europäisches Patentamt
European Patent Office
Office européen des brevets

(11) **EP 2 434 494 A1**

(12) # EUROPEAN PATENT APPLICATION

(43) Date of publication:
**28.03.2012 Bulletin 2012/13**

(51) Int Cl.:
***G11C 11/417*** *(2006.01)*

(21) Application number: **10192908.1**

(22) Date of filing: **29.11.2010**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **27.09.2010 US 386863 P**

(71) Applicant: **SuVolta, Inc.**
**Los Gatos, CA 95032 (US)**

(72) Inventor: **Thummalapally, Damodar R.**
**Milpitas, CA 95035 (US)**

(74) Representative: **DeVile, Jonathan Mark**
**D Young & Co LLP**
**120 Holborn**
**London EC1N 2DY (GB)**

(54) **Integrated circuit devices and methods**

(57)    An integrated circuit device (400) may include a plurality of memory cells arranged into groups (402) formed in a semiconductor substrate, each group (402) having a plurality of rows and columns, each memory cell having at least a first bias connection; a biasing network (522) for each group that includes a plurality of first conductive lines (524) disposed in the column direction having conductive connections to the bias connections of its group and not adjacent groups; and a different source switch (516) coupled to each biasing network (522) that selectively applies at least one bias voltage to the memory cells of the group to alter leakage characteristics of such memory cells.

FIG. 4

EP 2 434 494 A1

COL. DIR.

ROW DIR.

520

502

522

524

SW_EN

516

Vbias2

518

FIG. 5A

COL. DIR.

520'

ROW DIR.

502'

524-1

516-1

SW_EN

516-0

518'

524-0

Vbias2

FIG. 5B

COL. DIR.

ROW DIR.

620

602'

614

624

622'

628

SW_EN

616'

618

Vbias2

FIG. 6

COL. DIR.

ROW DIR.

720

702'

714

724

722'

728

SW_EN

716'

718

Vbias2

FIG. 7

**Description**

TECHNICAL FIELD

The present invention relates generally to integrated circuits.
In some examples the integrated circuits are arranged to have two or more modes of operation based on varying transistor biasing conditions.

BACKGROUND

Integrated circuit (IC) devices continue to enjoy a fundamental role in electronic systems, ranging from large server "farms" that enable the wide variety of Internet services and businesses, and can include hundreds or even thousands of server computers, to the smallest of portable electronic devices. In many such electronic devices and systems, reductions in power consumption remain an important goal. In the case of large systems, reductions in power consumption can reduce power costs of an enterprise. In the case of portable electronic devices, reductions in power consumption can advantageously lead to longer battery life and/or the ability to provide additional functions for a given amount of charge.
IC devices typically include numerous transistors (up to millions of such devices) operated and arranged to provide the various functions of an electronic device. To address power concerns, some ICs may have both active and stand-by states. In an active state, transistors may have electrical conditions (i.e., may be "biased") that enable them to reliably switch, or otherwise conduct current, and thereby enable the IC to function as desired. In a stand-by state, transistors are biased to draw as little current as practical, at the expense of not being operational.
ICs may include various circuit types, including digital circuits, which typically switch between one logic value ("0") and another logic value ("1"), as well as analog circuits, which may manipulate manage voltage, current and/or charge at various levels.
One particular circuit type is the "static" random access memory (SRAM). An SRAM may store data values in a memory cell array, but unlike other memory types, such data values may be accessed at relatively fast speeds (nanoseconds). Conventionally, SRAMs have provided performance (e.g., speed) advantages at the cost of relatively large power consumption. Conventional SRAMs that switch biasing conditions to address power consumption are known. Some conventional approaches place the entire SRAM array into an active or standby mode. Unfortunately, maintaining an entire array in active mode may still draw considerable current (and hence consume more power than desired). Other conventional approaches may change bias conditions on a row-wise basis. While such approaches may reduce power consumption, the inclusion of such switching devices may consume undesirably large amounts of area on the IC, which can directly translate into increased costs. In addition, such approaches require the inclusion of switching devices at locations that may complicate designs.
Various aspects and features of the present invention are defined in the appended claim

BRIEF DESCRIPTION OF THE DRAWINGS

Embodiments of the invention will now be described with reference to the accompanying drawings, throughout which like parts are referred to by like references, and in which:

FIGS. 1A and 1B are block schematic diagrams of a memory device according to one embodiment.
FIG. 2 is a block schematic diagram of a memory device according to another embodiment.
FIG. 3 is a block schematic diagram of a conventional memory device.
FIG. 4 is a plan view of a memory device according to an embodiment.
FIGS. 5A and 5B are diagrams of memory cell group architectures according to embodiments.
FIG. 6 is a diagram of a memory cell group architecture according to another embodiment.
FIG. 7 is a diagram of a memory cell group architecture according to a further embodiment.
FIG. 8 is a plan view of a memory device according to another embodiment.
FIG. 9 is a block schematic diagram of a memory device according to another embodiment.
FIG. 10 is a plan view of a memory device according to another embodiment.
FIG. 11 is a block schematic diagram of a memory device according to another embodiment.
FIG. 12 is a block schematic diagram of a memory device according to a further embodiment.
FIGS. 13A to 13C are schematic diagrams of memory devices according to embodiments.
FIG. 14 is a plan view of a memory device biasing architecture according to an embodiment.
FIG. 15 is a block schematic diagram of a memory device according to a further embodiment.
FIG. 16 is a plan view of a memory device biasing architecture according to another embodiment.

FIG. 17 is a block schematic diagram of a memory device according to a further embodiment.

FIG. 18 is a timing diagram showing a source switching operation according to an embodiment.

FIG. 19 is a timing diagram showing a source and well switching operation according to an embodiment.

FIG. 20 is a block schematic diagram of a decoder circuit that may be included in embodiments.

FIG. 21A is a block schematic diagram of a memory device according to a further embodiment.

FIG. 21B is a schematic diagram of select logic that may be included in embodiments.

FIGS. 22A and 22B are block schematic diagrams of a memory device according to a further embodiment.

FIG. 23 is a table showing very particular examples of dynamic source switching levels that may be included in embodiments.

FIG. 24 is a table showing very particular examples of dynamic body bias switching levels that may be used in embodiments.

FIGS. 25A to 25C are side cross sectional views showing substrate structures that may be included in embodiments.

FIG. 26 is perspective view of an alternate substrate structure that may be included in embodiments.

FIG. 27 is perspective view of another substrate structure that may be included in embodiments.

FIG. 28 is perspective view of a further substrate structure that may be included in embodiments.

FIG. 29 is a side cross sectional view showing a further substrate structure that may be included in embodiments.

FIG. 30 is a side cross sectional view of a partial trench isolation structure that may be included in the embodiments.

FIG. 31 is a side cross sectional view of a deeply depleted channel (DDC) transistor structure that may be included in embodiments.

FIGS. 32A to 32C are top plan views of a six transistor (6-T) static random access memory (SRAM) cell according to one embodiment.

FIGS. 33A to 33C are top plan views of two dynamic source switching elements according to one embodiment.

## DETAILED DESCRIPTION

Various embodiments of the present invention will now be described in detail with reference to a number of drawings. The embodiments show circuits and methods related to an integrated circuit device having transistors that may be switched from an inactive, lower leakage current mode to an active higher leakage current mode. Particular embodiments may include static random access memories having decoded groups that are active upon being accessed, and otherwise remain inactive.

In the various embodiments below, like items are referred to by the same reference character but the leading digits corresponding to the figure number.

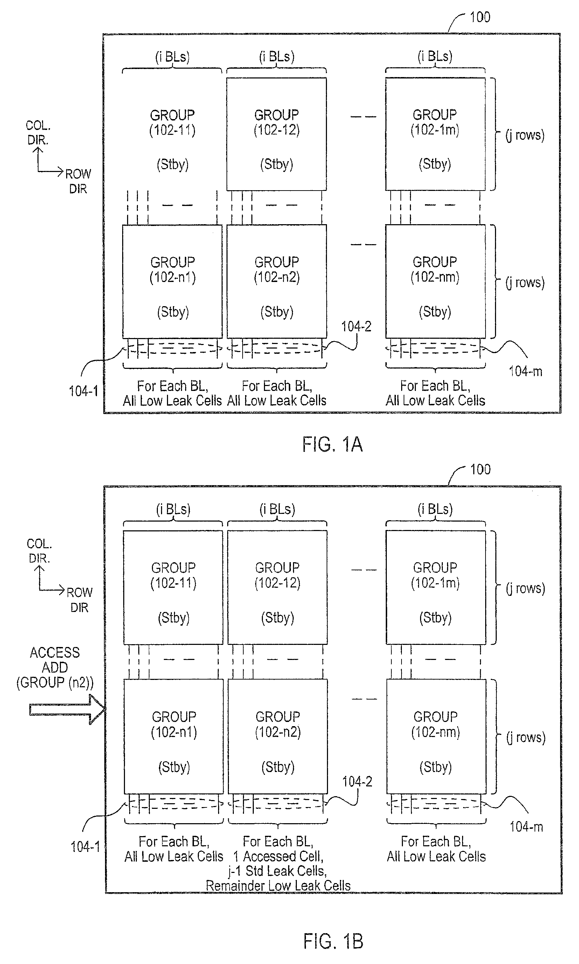

Referring now to FIGS. 1A and 1B, an integrated circuit device according to an embodiment, which in this case is a memory device, is shown in a block diagram and designated by the general reference character **100.** A memory device **100** may include a number of cell groups **102**-11 to -nm, each cell group (**102**-11 to -nm) including memory cells arranged into multiple rows and columns. In the embodiment shown, cell groups (**102**-11 to -nm) may be arranged into an n x m array, having n groups in the column direction and m groups in the row direction (where n is greater than 1). Bit lines **104**-1 tom may extend over multiple cell groups (**102**-11 to -nm). That is, one bit line may access columns of memory cells in multiple cell groups (**102**-11 to -nm). In the very particular embodiment shown, each cell group (**102**-11 to -nm) may be connected to "i" bit lines and include "j" rows of memory cells.

Each cell group (**102**-11 to -nm) may have at least two different modes of operation. In some embodiments, such modes may include a low leakage, lower access speed mode and a higher leakage, faster speed mode. In one embodiment, all cell groups (**102**-11 to - nm) may be separately switched between different modes in response to address information.

In a particular embodiment, in an active mode, memory cell accesses may be faster and/or more reliable as compared to a first mode. Further, absent an access operation (e.g., read or write), cell groups (**102**-11 to -nm) may be in a standby mode that may substantially reduce cell current leakage. In response to an access operation, a cell group (s) (**102**-11 to -nm) containing the accessed location(s) may be switched to the active mode. In this way, each cell groups (**102**-11 to -nm) may be conceptualized as being "only active upon access".

Cell groups (**102**-11 to -nm) may be switched between different modes of operation by altering a bias voltage applied to all memory cells of the group. In one embodiment, each memory cell may include one or more transistors having a source connection, and different performance modes may result by altering a bias voltage to such source connection(s) for such transistors in the group. In addition or alternatively, each memory cell may include one or more transistors having body connections, and different performance modes may result by altering a body bias voltage to such body connection(s) for all such transistors of the group.

Referring still to FIGS. 1A and 1B, an example of an access operation according to one embodiment will now be described. In the operations discussed below, it is assumed that a bit lines may be organized into "m" bit line sets **104**-1 to **104**-m. Each bit line may have connections to a column of each cell group in the column direction. For example, bit line set **104**-2 may have connections to columns of cell groups **102**-12 and **102**-n2.

FIG. 1A shows a memory device **100** in a default state. A default state **100** may be a state in which memory cells are not being accessed. Each cell group **(102**-11 to -nm) may be in a first mode (show in the figure as "Stby"). Such a first mode may be a low leakage mode. Consequently, each bit line may be connected to j x n memory cells, with all such memory cells being in a low leakage mode.

FIG. 1B shows an operation of memory device **100** in response to receiving an access address (ACCESS ADD). It is understood that such address information may be received in combination with control and/or timing information that indicates a type of access (e.g., read or write) and/or access features (e.g., single location, burst length or type, etc.). Further, only a portion of an access address (ACCESS ADD) may be decoded to derive which memory cell group (s) **(102**-11 to -nm) is accessed.

In the example shown, it is assumed that an access address (ACCESS ADD) corresponds to a location within cell group **102**-n2. Accordingly, in response to such an access address, cell group **102**-n2 may be switched from a first mode (Stby) to a second mode (shown in the figure as "Act"). In the embodiment shown, it is assumed that a first mode (Stby) is a low leakage mode and a second mode (Act) is a higher performance mode. Consequently, all but one set of "i" bit lines may remain connected to cell groups in the low leakage mode. For the set of "i" bit lines **(104**-2) connected to the accessed cell group **(102**-n1), each bit line may be connected to one accessed memory cell, j-1 standard leakage cells, and j x (n-1) low leakage cells.

In this way, an integrated circuit device may be divided into separately biased transistor groups, where each transistor group may be switched from a default bias state to an access bias state in response to an access operation. While FIG. 1 shows a memory device switched between states in response to a memory access operation, non-memory device embodiments may determine access based on input signals to a given section. That is, one section of logic may be switched from a default bias state to an access bias state when it received input signals, while other logic sections remain in the default bias state.

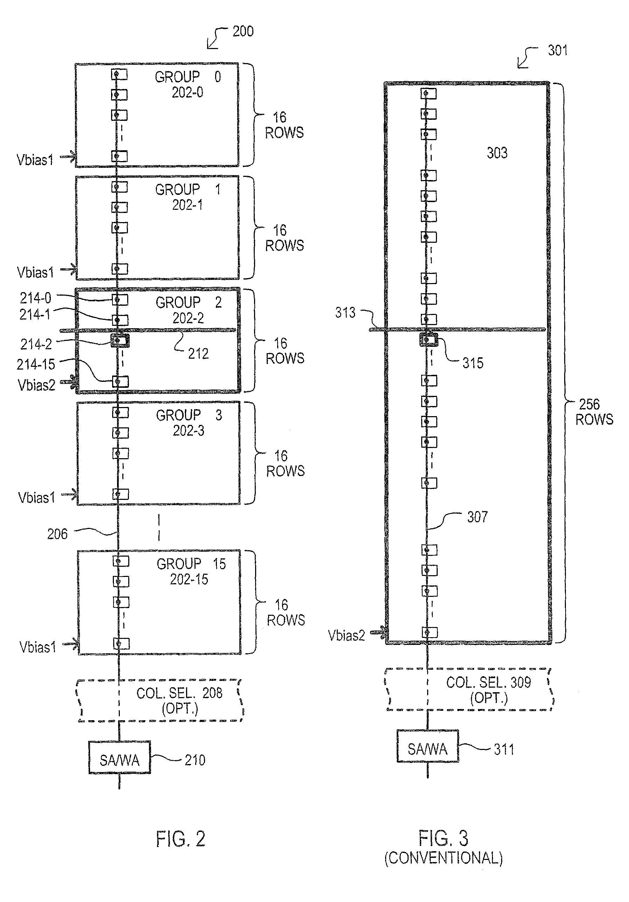

Referring to FIG. 2, a memory device according to another embodiment is shown in a block schematic diagram and designated by the general reference character **200.** In one particular arrangement, a memory device **200** may be one implementation of that shown in FIGS. 1A and 1B.

In the embodiment of FIG. 2, memory device **200** may include 16 cell groups **202**-0 to -15, each cell group **(202**-0 to -15) having 16 rows. Within each cell group **(202**-0 to - 15), each row of memory cells may be accessed by a corresponding word line, and each column of memory cells may be connected to a same bit line. For illustrative purposes, FIG. 2 shows only the bit line **206** and word line **212** corresponding to one accessed memory cell 214-2.

A bit line **206** may be connected to a read/write circuit **210** directly, or by way of an optional column select circuit **208.** In a read operation, read/write circuit **210** may sense a read data value on bit line **206** with a sense amplifier (SA). It is understood that in some embodiments, a sense amplifier may sense a voltage differential between bit line pairs. In a write operation, a write data value may be driven on bit line **206** by a write amplifier (WA), or the like. As in the case of the sense amplifier (SA), it is understood that in some embodiments, a write amplifier may drive a differential voltage on bit line pairs. A column select circuit **208** may multiplex multiple bit lines (or bit line pairs) to a sense amplifier, write amplifier, or input/output paths.

FIG. 2 shows an operation that accesses cell group **202**-2. As a result, a bias voltage applied to cell group **202-**2 may switch to Vbias2 from Vbias1, while the non-accessed cell groups (202-0, -1, and -3 to -15) may continue to receive a bias voltage Vbias1. In addition, a word line **212** within cell group **202**-2 may be activated, connecting memory cells of a corresponding row to their particular bit line(s).

Referring still to FIG. 2, under the conditions illustrated, a leakage current with respect to bit line **206** (I_BL) may be represented by:

$$I\_BL = ICell\_Active + (15*ICell\_Std) + (240*ICell\_Low)$$

where ICell_Active corresponds to memory cell **214**-2 accessed by activated word line **212,** ICell_Std corresponds to non-accessed memory cells **(214**-0 to -1 and -3 to -15), and ICell_Low corresponds to the memory cells connected to bit line **206** in the non-accessed cell groups **(202**-0, -1, and -3 to -15).

FIG. 3 shows a conventional memory device **301** for comparison with that shown in FIG. 2. Memory device **301** may include a common memory cell array **303** having 256 rows of memory cells. Each row of memory cells may be accessed by a corresponding word line, and each column of memory cells may be connected to a same bit line. For illustrative purposes, FIG. 3 shows only the bit line **307** and word line **313** corresponding to one accessed memory cell **315.**

A bit line **307** may be connected to a read/write circuit **311** directly, or by way of an optional column select circuit **309.**

FIG. 3 shows an operation that accesses memory cell **315** within array **303**. All memory cells within array **303** may receive a same bias voltage Vbias2.

Under the conditions illustrated in FIG. 3, a leakage current with respect to bit line **307** (I_BL(conv)) may be represented by:

$$I\_BL(conv) = ICell\_Active + (255*ICell\_Std)$$

where ICell_Active corresponds to memory cell **315** accessed by activated word line **313,** ICell_Std corresponds to the remaining non-accessed memory cells connected to bit line **307.**

A comparison between bit line leakage values for FIGS. 2 and 3 shows that when low leakage bias conditions substantially reduce cell leakage (i.e., ICell_Low <<< ICell_Std), a bit line according to the embodiment of FIG. 2 may have substantially smaller bit line leakage current than the conventional case shown in FIG. 3

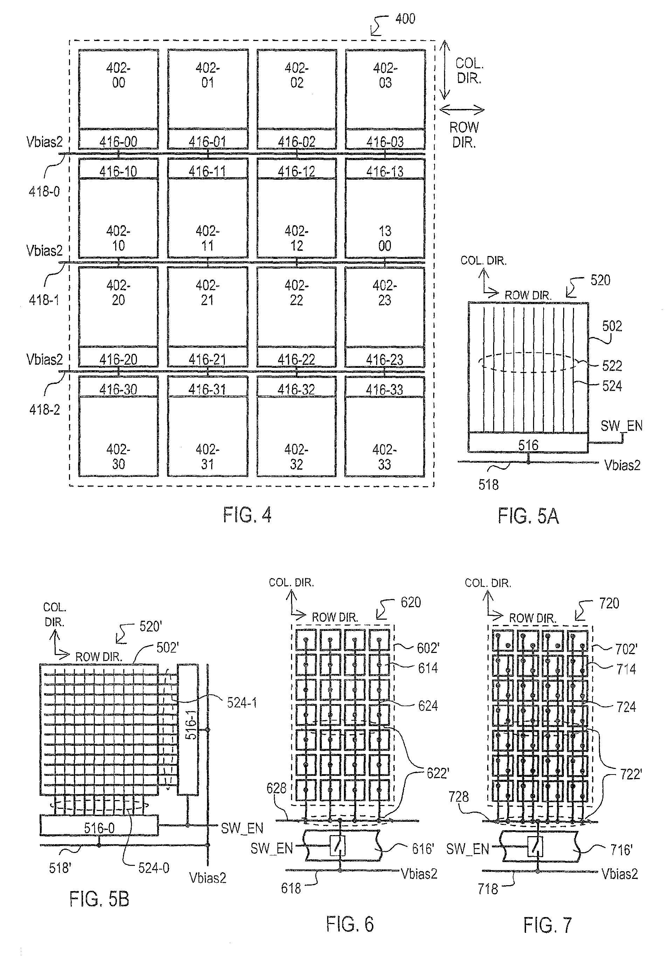

Referring now to FIG. 4, a memory device according to a further embodiment is shown in a general plan view and designated by the general reference character **400.** In one particular arrangement, a memory device **400** may one implementation of that shown in FIGS. 1 and/or 3.

A memory device **400** shows an embodiment in which different memory cell groups may have bias conditions varied by a source switch circuit. A memory device **400** may include a number of cell groups **402**-00 to -33, as well as a switch circuit **416**-00 to -33 corresponding to each cell group (**402**-00 to -33).

Each cell group (**402**-00 to -33) may include memory cells arranged into multiple rows, each such memory cell including at least one transistor having a source-drain path, and a source connection. In one embodiment, each memory cell may include multiple transistors, more particularly, at least two transistors in a cross-coupled configuration, both having sources connected to the source connection of the memory cell.

Each switch circuit (**416**-00 to -33) may provide a controllable switch path between the source connection of the memory cells of its corresponding cell group, but not to memory cells of any other groups. Thus, switch circuits (**416**-00 to -33) may enable separately controlled source biasing for the transistors of their corresponding cell group (**402**-00 to -33).

Referring still to FIG. 4, in the particular embodiment shown, each switch circuit (416-00 to -33) may be physically situated at one end of its corresponding cell group (**402-**00 to -33) in the column direction. Further, switch circuits (**416**-00 to -33) may be adjacent to one another in the column direction. For example, switch circuit **416**-00 is adjacent to switch circuit **416**-10, switch circuit **416**-01 is adjacent to switch circuit **416**-11, etc.

In other embodiments, switch circuits may be located at a center of their respective cell group, biasing transistors in cells above and below the switch circuits in the column direction.

As shown in FIG. 4, a bias supply line (**418**-0 to -2) may be formed between adjacent switch circuits (**416**-00 to -33) in the row direction. Bias supply lines (**418**-0 to -2) may provide a bias voltage (Vbias2) to the switch circuits (**416**-00 to -33).

In one embodiment, absent any access to a cell group (**402**-00 to -33), switch circuits (**416**-00 to -33) may isolate their respective memory cell sources from bias voltage (Vbias2), and sources of memory cell transistors in all groups may be at another bias voltage (e.g., Vbias1, not shown). In response to an access operation to a cell group (**402-**00 to -33), the switch circuit (**416**-00 to -33) corresponding to the cell group may apply the received bias voltage (Vbias2) to the memory cell sources in its cell group, thereby altering the performance of the cell group (e.g., higher leakage, faster performance).

In this way, a memory device may include switch circuits dedicated to different cell groups to enable separate source bias control of such groups.

Referring now to FIG. 5A, a memory cell group architecture according to an embodiment is shown in general plan view and designated by the general reference character **520**. It is understood that group architecture **520** may be repeated numerous times to arrive at a memory device with multiple groups. In one arrangement, group architecture may be repeated to form all or a part of memory device **400** shown in FIG. 4.

Group architecture **520** may included a cell group **502,** switch circuit **516,** bias supply line **518,** and a source bias network **522**. A cell group **502 may** include memory cells arranged into rows and columns, each such memory cell having multiple transistors, at least one of which has a source connected to a source connection (not shown). Source connections of memory cells may be connected to source bias network **522**.

Switch circuit **516** may selectively apply bias voltage Vbias2 on bias supply line **518** to bias network **522 in** response to a source selection signal SW_EN. Switch circuit **516** may include one or more controllable impedance paths between bias supply line **518** and source bias network **522**. **A** source selection signal SW_EN may be unique to cell group **502** (or a small subset of all cell groups) to enable switch circuit **516** to bias memory cell group **502** separately from other cell groups.

In one embodiment, a bias voltage Vbias2 may be a power supply voltage (e.g., VSS or ground for n-channel transistors, or alternatively VDD for p-channel transistors). Further, within switch circuit 516 there may be a bias circuit that enables a source bias network to return to a default bias voltage that is between the supply voltages (i.e., if Vbias2 = VSS, Vbias1 > Vbias2, if Vbias2 = VDD, Vbias1 < Vbias2).

Source bias network 522 may include a number of conductive source bias lines (one shown as 524) arranged in the column direction. In one embodiment, each source bias line (e.g., 524) may be connected to sources of memory cells of its cell group 502, and not to memory cells of any other groups. In this way, a source bias network 522 may provide a source biasing network independent of any other cell group.

In this way, each cell group of a memory device may include a source bias network having multiple conductive lines in a column direction connected to sources of memory cells in the cell group.

Referring now to FIG. 5B, a memory cell group architecture according to another embodiment is shown in general plan view and designated by the general reference character 520'. It is understood that group architecture 520' may be repeated numerous times to arrive at a memory device with multiple groups. In one arrangement, group architecture may be repeated to form all or a part of memory device 400 shown in FIG. 4.

Group architecture 520' may include a cell group 502', first switch circuits 516-0, second switch circuits 516-1, bias supply line 518', first source bias lines 524-0 and second source bias lines 524-1. As in the case of FIG. 5A, a cell group 502' may include memory cells arranged into rows and columns, each such memory cell having multiple transistors, at least one of which has a source connected to a source connection (not shown).

First source bias lines 524-0 may extend in a column direction, while second source bias lines 524-1 may extend in a row direction. First and second source bias lines (524-0/1) may have source connections to transistors within cell group 502'. In some embodiments, first source bias lines 524-0 may be electrically shorted to second source bias lines 524-1 to form a source bias "grid" for cell group 502'. In a particular embodiments, first source bias lines 524-0 may be formed from one conductive layer, while second source bias lines 524-0 may be formed from another conductive layer.

Switch circuit 516-0 may selectively connect first source bias lines 524-0 to bias supply line 518' in response to a source selection signal SW_EN. Similarly, switch circuit 516-1 may selectively connect second source bias lines 524-1 to bias supply line 518' in response to a source selection signal SW_EN.

Including multiple switch circuits (in this embodiments, two 516-0/1) on more than one side of a cell group, may enable greater current sourcing capabilities, and or enable smaller switch circuit sizes.

In this way, source switches may drive a source bias network from both a row direction and a column direction.

Referring now to FIG. 6, a memory cell group architecture according to another embodiment is shown in general plan view and designated by the general reference character 620. As in the case of FIG. 5, group architecture 620 may be repeated numerous times to arrive at a memory device with multiple groups, such as that shown in FIG. 4.

The group architecture 620 of FIG. 6 shows a cell group portion 602', switch circuit portion 616', bias supply line 618, and a source bias network portion 622'. Cell group portion 602' shows 28 memory cells (one shown as 614) forming part of four columns and seven rows of a memory cell array. Each memory cell (e.g., 614) may have at least one source connection to one or more sources of transistors within the memory cell.

Switch circuit 616' portion may connect a bias supply line 618 to source bias network 622' in response to a source selection signal SW_EN.

Source bias network portion 622' may include a number of conductive source bias lines (one shown as 624) as well as a shorting line 628. In the embodiment shown, a source bias line (e.g., 624) may be provided for each column of a cell group 602. Further, each source line bias line (e.g., 624) may have a direct current path to a source (or sources) of the memory cells of its corresponding column. A shorting line 628 may be a conductive line that connects all source bias lines (e.g., 624) of a same cell group to one another, forming a common source bias network 622' for the cell group.

In one embodiment, a shorting line 628 may extend in the row direction adjacent to, within, or over a corresponding switch circuit 616. However, in other embodiments, a shorting line 628 may have other orientations with respect to corresponding source bias lines (e.g., 624). In a very particular embodiment, a shorting line 628 may be formed from a different metallization layer than source bias lines (e.g., 624).

In this way, each cell group of a memory device may include a source bias network having multiple source bias lines in a column direction and one or more shorting lines that conductively connect the source bias lines to one another.

Referring now to FIG. 7, a memory cell group architecture according to a further embodiment is shown in general plan view and designated by the general reference character 720. As in the case of FIG. 5, group architecture 720 may be repeated numerous times to arrive at a memory device with multiple groups, like that shown in FIG. 4. Group architecture 720 may have items like those of FIG. 6, accordingly, like items are identified with the same reference character but with the first digit being "7".

A group architecture 720 may differ from that of FIG. 6 in that each memory cell (e.g., 714) may include two source connections. In one embodiment, such two source connections are for two transistors of the same conductivity type.

Further, in FIG. 7 a source bias network portion **722'** may include a pair of source bias lines (one shown as **724)** connected to memory cells of each column.

In this way, each cell group of a memory device may include a source bias network having two conductive bias lines for each column within a cell group.

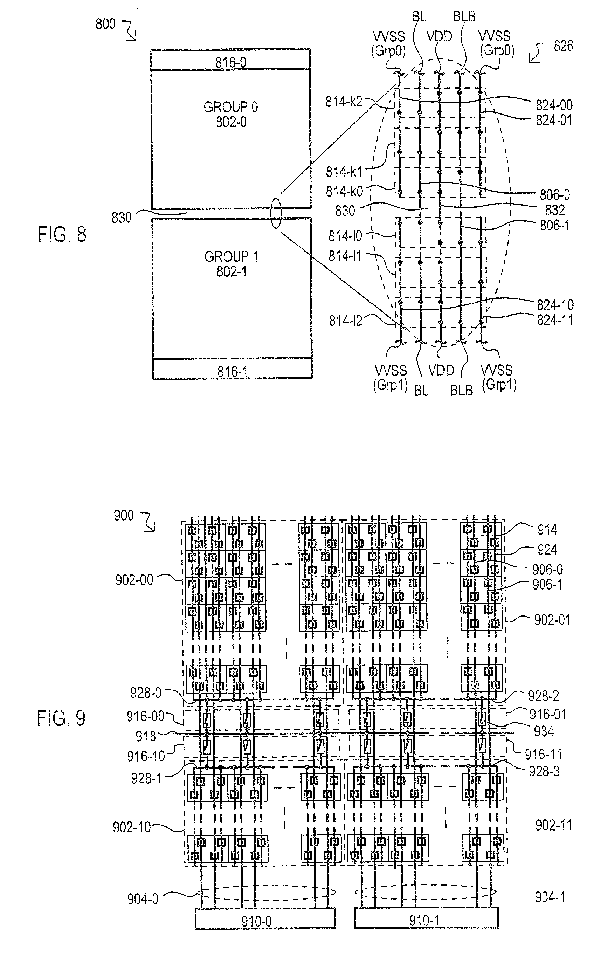

Referring now to FIG. 8, memory device according to an embodiment is shown in a plan view and designated by the general reference character **800.** In very particular arrangements, memory device **800** may be one implementation of any of those shown in FIGS. 1A/B, 2 or 4.

A memory device **800** may include memory cell groups **802**-0/1 and a switch circuit **816**-0/1 corresponding to each cell group (**802**-0/1). Cell groups **802**-0/1 may be electrically separated from one another in a substrate by a separation region **830.** Such an electrical separation may include one or more isolation structures formed into the substrate.

In the embodiment of FIG. 8, various conductive lines may be formed over each cell group **(802**-0/1), with some extending over separation region **830** (and hence being shared by memory cell groups), while others do not span separation region 830 (and hence may be unique to the memory cell group).

According to an embodiment, memory cells of both cell groups 802-0/1 may share connections to one or more bit lines and one or more power supply lines. At the same time, memory cells of each cell group **802**-0/1 may have connections to source bias lines limited to cell group. Magnified area **826** shows one example of such an arrangement.

Referring now to magnified area **826,** a memory device **802** may include first group memory cells **814**-k0 to -k2 separated from second group memory cells **814**-10 to -12 separated from one another by separation region **830.** First group memory cells (**814**-k0 to -k2) may be connected to source bias lines **824**-00 and **824**-01 that do not extend into separation region **830.** Thus, source bias lines **824**-00/01 may not be connected to second group memory cells (**814**-I0 to -I2). In the same way, second group memory cells (**814**-I0 to -I2) may be connected to source bias lines **824**-10 and **824**-11 that do not extend into separation region **830.**

Referring still to magnified area **826,** in contrast to source bias lines (**824**-00 to **824-**11), bit lines **806**-0/1 and a power supply line **832** may span separation region **830,** and be connected to both first and second group memory cells (**814**-k0 to -I2).

In this way, adjacent cell groups of a memory device may have a substrate separation region, and source bias lines may not extend over the separation region, while other lines may extend over the separation regions.

Referring now to FIG. 9, a memory device according to another embodiment is shown in a block schematic diagram and designated by the general reference character **900.** In very particular arrangements, memory device **900** may be one implementation of any of those shown in FIGS. 1A/B, 2 or 4.

A memory device **900** may include memory cell groups **902**-00 to -11, corresponding switch circuits **916**-00 to -11, a bias supply line **918,** and read and/or write circuits **910**-0/1. Cell groups (**902**-00 to -11) may include a number of memory cells (one shown as **914**), each having two source connections and two bit line connections. Cell groups **902**-00/01 may be separated from cell groups **902**-10/11 by corresponding switch circuits (**916**-00 to -11).

Each cell group (**902**-00 to -11) may have a corresponding source bias network including two source bias lines (one shown as **924**) as well as a shorting line **928**-0 to -3. Source bias lines (e.g., **924)** may be connected to sources of memory cells of a same column, and shorting lines (**928**-0 to -3) may connect source bias lines **924** of a same cell group to one another. As but one example, each cell group may have a source bias network like that shown in FIG. 7.

Switch circuits (**916**-00 to -11) may include multiple switch elements (one shown as **934**). In the particular embodiment shown, each switch circuit (**916**-00 to -11) may have a switch element (e.g., **934**) corresponding to each column of memory cells in the corresponding cell group (**902**-00 to -11).

In the embodiment of FIG. 9, various conductive lines may be formed over each cell group (**902**-0/1), with some extending over switch circuits (**916**-00 to -11), while others only extending over the corresponding cell group (and hence are unique to the memory cell group). Source bias lines (e.g., **924**) may be connected to memory cell columns of the their respective cell group, and not to any adjacent cell group. In contrast, bit lines (e.g., **906**-0/1) may extend over switch circuits (**916**-00 to -11) connecting a column of cell group to a corresponding column in an adjacent cell group. In FIG. 9, one bit line set 904-0 connects columns of cell group **902**-00 to corresponding columns of cell group **902**-10, while bit line set **904**-1 connects columns of cell group **902**-01 to corresponding columns, of cell group **902**-11.

R/W circuit **910**-0 may read and/or write data to locations in cell groups **902**-00 or 01 via bit line set **904**-0. In the same manner, circuit 910-1 may read and/or write data to locations in cell groups **902**-10 or -11via bit line set **904**-1.

In this way, adjacent cell groups of a memory device may be separated by source biasing switch circuits, with bit liens extending over such regions.

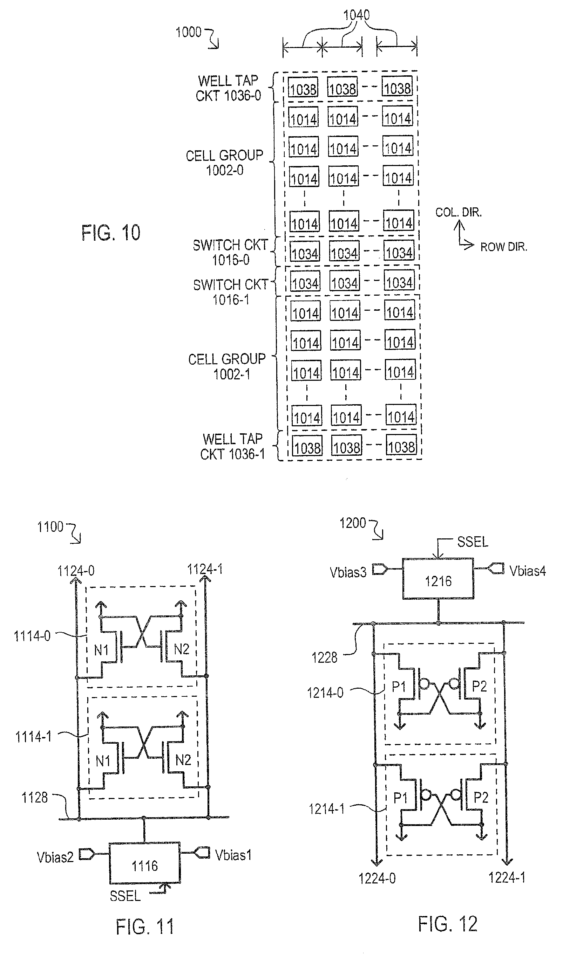

Referring now to FIG. 10, a memory device according to an embodiment is shown in a top plan view and designated by the general reference character **1000.** In very particular arrangements, memory device **1000** may implement other embodiments shown herein. In the embodiment of FIG. 10, various sections of a memory may be formed from elements that fit within a memory cell pitch in a columns direction.

A memory device **1000** may include memory cell groups **1002**-0/1, switch circuits **1016**-0/1, and optionally, well taps **1036**-0/1. Cell groups **1002**-0/1 may each include a number of memory cells **1014** having a pitch **1040** in a row direction. It is understood that memory cells **1014** may have substantially the same design (including, being mirror images of one another).

Switch circuit **1016**-0 may provide one or more source bias voltages to the memory cells **1014** of cell group cell group **1002**-0. Switch circuit **1016**-0 may include switch elements **1034** that fit within pitch **1040**. Switch elements **1034** may be substantially similar to one another. In particular embodiments, switch elements **1034** may have diffusion region within a substrate that generally follow those of memory cells **1014**. In the same fashion, switch circuit **1016**-1 may provide one or more source bias voltages to the memory cells **1014** of cell group cell group **1002**-1, and include switch elements **1034** that fit within pitch **1040** and are substantially similar the switch elements of switch circuit **1016**-0.

In other embodiments, switch elements (e.g., **1034**) may be situated on multiple sides of a cell group, as shown in FIG. 5B. That is, switch elements may extend in a vertical direction in FIG. 10.

Optional well tap circuit **1036**-0 may provide one or more well bias voltages to the memory cells **1014** of cell group cell group **1002**-0, and optional well tap circuit **1036**-1 may provide one or more well bias voltages to the memory cells **1014** of cell group cell group **1002**-1. As in the other circuit sections above, each well tap circuit **1036**-0/1 may include tap elements **1038** that fit within pitch **1040**. Tap elements **1038** may be substantially similar to one another, and in particular embodiments, may have diffusion region within a substrate that generally follow those of memory cells **1014**.

In this way, a memory device may include source bias switch circuits having repeated switch elements that fit within a memory array column pitch. Optionally, well tap circuits may include repeated well tap elements that also fit within the memory array column pitch.

Referring now to FIG. 11, a memory device according to another embodiment is shown in a schematic diagram and designated by the general reference character **1100**. A memory device **1100** may be one implementation of embodiments shown herein, and equivalents.

Memory device **1100** may include memory cells **1114**-0/1 each connected to two different source bias lines **1124**-0/1. Source bias lines 1124-0/1 may be connected to a shorting line **1128**. Source bias lines **1124**-0/1 in combination with shorting line **1128** may form a source biasing network for memory cells **1114**-0/1.

Switch circuit **1116** may provide one or more bias voltages to the source biasing network, to thereby place memory cells **1114**-0/1 into different modes of operation. In one embodiment, one mode may have a low leakage and slower access speed, while the other may have higher leakage and a higher access speed.

Each memory cell may include at least two transistors having sources connected to different source bias lines. In the particular embodiment shown, each memory cell **1114**-0/1 may be part of a same column and include two n-channel transistors N1/N2. Transistors N1/N2 may have a cross-coupled configuration (having their drains connected each other's gates), and sources connected to different source bias lines **1124**-0/1. It is understood that memory cells **1114**-0/1 may include additional transistors (not shown).

Referring now to FIG. 12, a memory device according to a further embodiment is shown in a schematic diagram and designated by the general reference character **1200**. A memory device **1200** may also be one implementation of embodiments shown herein, and equivalents. Memory device **1200** has the same general arrangement of that shown in FIG. 11, but with source bias lines **1224**-0/1 connected to sources of p-channel transistors P1/P2 within each memory cell **1214**-0/1.

In this way, a memory device may include memory cells with two transistors having sources connected to different source bias lines extending in the column direction.

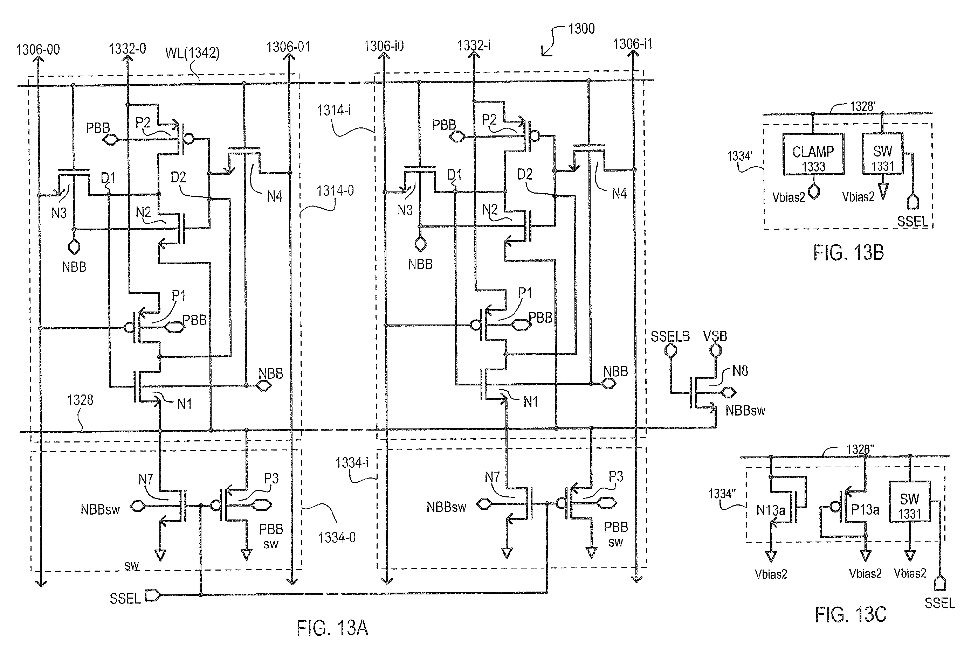

Referring to FIG. 13A, a memory device according to an embodiment is shown in a schematic diagram and designated by the general reference character **1300**. Memory device **1300** may include a row of multiple memory cells **1314**-0 to -i and corresponding switch elements **1334**-0 to -i. Memory cells (**1314**-0 to -i) may be static random access memory (SRAM) cells. In the particular embodiment shown, each memory cell (**1314**-0 to -i) may be a six transistor (6T) memory cell, having a cross-coupled pair of n-channel pull-down transistors (N1/N2), a cross-coupled pair of p-channel pull-up transistors (P1,P2), and two n-channel access transistors (N3/N4).

Memory cell **1314**-0 will now be described in detail. It is understood that the remaining memory cells may have the same structure, and be coupled to a same word line **1342** and same shorting line **1328**.

As shown in FIG. 13A, pull-down transistors N1/N2 may have sources electrically connected to a shorting line **1328** common to memory cells **1314**-0/1. In some embodiments, such a connection may be by way of source bias lines (not shown) extending in a column direction connected to other memory cells of same column. Drains of transistors N1/N2 may be connected to complementary data nodes D1 and D2, respectively, with gates having a cross-coupled connection to such data nodes.

Pull-up transistors P1/P2 may have sources commonly connected to a same power supply line **1332**-0. In some embodiments, a power supply line may extend in a column direction connected and may be connected to other memory cells of same column. Drains of transistors P1/P2 may be connected to complementary data nodes D1 and D2, respectively, with gates having a cross-coupled connection to such data nodes.

Access transistor N3 may have a source-drain path connected between a bit line **1306**-00 and data node D1, and access transistor N4 may have a source-drain path connected between a bit line **1306**-01 and data node D2. Gates of access transistors N3/N4 may be connected to a word line **1342**.

Within each memory cell (**1314**-0 to -i) n-channel devices (N1, N2, N3, N4) may have bodies commonly connected to an n-type body bias node NBB. Similarly, each p-channel device (P1, P2) may have a body connected to a p-type body bias node PBB. In some embodiments, body bias nodes (NBB, PBB) may be maintained at a constant bias voltage (e.g., high, low power supplies). However, in other embodiments, body bias nodes (NBB, PBB) may be switched between two or more body bias voltages to alter transistor performance. Particular embodiments having dynamic body bias switching will be described below.

Switch circuit **1334**-0 will now be described in detail. It is understood that the remaining switch circuits may have the same structure, and be coupled to shorting line **1328** common to all rows in a cell group.

Each switch element (**1334**-0 to -i) may include a switch transistor N7, as well as clamp transistor P3. Switch transistor N7 and clamp transistor P3 may have a source-drain paths connected between shorting line **1328** and bias voltage VSS. Transistors N7 and P3 may have gates connected to a source select signal SSEL. A body of N7 may be connected to a body bias node NBBsw, and a body of transistor P3 may be connected to a body bias node PBBsw. In some embodiments, such body bias nodes (NBBsw/PBBsw) may be the same as those of the memory cells (NBB/PBB), thus bodies of devices within switch elements may be biased with corresponding bodies of memory cell devices. However, in other embodiments, bodies of devices within switch elements may be biased separately from corresponding bodies of memory cell devices.

Optionally, a memory device **1300** may further include a bias device N8. A bias device N8 may provide a controllable impedance path between shorting line **1328** and a bias voltage VSB. Bias voltage VSB may be higher than VSS. In the particular embodiment shown, a shorting device N8 may be an n-channel transistor having a source-drain path between shorting line **1328** and bias voltage VSB. A gate of transistor N8 may receive signal SSELB, which may be an inverse of source select signal SSEL.

It is understood that while FIG. 13A shows one row of memory cells (**1314**-0 to -i), additional rows of memory cells may be connected to bit line pairs (**1306**-00/01 to -i0/i1) in a repeated fashion, each such row having its own word line.

Having described various circuit sections of memory device **1300,** the operation of such a device will now be described.

Prior to an access operation, word line **1342** may be inactive (low in this case), and source select signal may be inactive (SSEL low, SSELB high). Consequently, access transistors N3/N4 may be turned off, and memory cells (**1314**-0 to -i) can be isolated from bit lines (**1306**-00/01 to -i0/i1). Within switch elements (**1334**-0 to -i), switch transistor N7 may be off, while clamp transistor P3 may have a clamping operation, being on or off depending upon its threshold voltage (Vtp) and the difference between the voltage of shorting line **1328** and bias voltage (VSS). Consequently, shorting line **1328** (and hence sources of pull-down transistors N1/N2) may be isolated from bias voltage VSS. In some embodiments, a clamping operation from a device such as P3 may establish a potential on shorting line **1328.** Optionally, a bias device N8 may also be included to pull a shorting line **1328** to a potential above VSS

In this state, due to the higher source bias voltage (e.g., greater than VSS) applied to pull-down transistors N1/N2, memory cells (**1314**-0 to -i) may be in a low leakage state.

In an access operation, a source select signal may be activated (SSEL high, SSELB low). Consequently, bias device N8 (if included) may be turned off, isolating shorting line **1328** from bias voltage VSB. In addition, clamp transistor P3 may be turned off, and switch transistor N7 may be turned on, pulling shorting line **1328** (and hence sources of pull-down transistors N1/N2) to the lower bias voltage VSS. In this state, due to the lower source bias voltage (e.g., VSS) applied to pull-down transistors N1/N2, memory cells (**1314**-0 to -i) may be in a relatively higher leakage state, which may also be a higher performance state (faster, higher data signal).

Following the activation of source select signal, a word line **1342** may be activated (WL high), turning on access transistors N3/N4 and thereby coupling data nodes D1/D2 to bit line pairs (**1306**-00/01 to -i0/i1). In a read operation, a differential voltage may be created on bit line pairs (1306-00/01 to -i0/i1). In a write operation, a differential voltage on bit lines may store a data value at nodes D1/D2 by a latching action of pull-down transistors (N1/N2) and pull-up transistors (P1/P2).

After a read or write operation, word line **1342** may be deactivated. Subsequently, source select signals (SSEL/SSELB) may return to inactive states. It is noted that the various switch transistors of the multiple switch elements (**1334**-0 to -i) may provide a current path that is substantially larger than that provided by bias device N8. Thus, a source bias network may be driven to VSS rapidly, placing the memory cells in an active state, as compared to a rate at which a clamping device (e.g., P3) or a bias device N8 (if included) may return such memory cells to the low leakage state.

Referring now to FIG. 13B, a switch circuit that may be included in embodiments is shown in a block schematic diagram and designated by the general reference character **1334'**. A switch circuit **1334'** may include a switch section **1331** and a clamp section **1333.** A switch section **1331** may be enabled by a switch enable signal SSEL to connect a shorting line **1328'** to a bias voltage Vbias2. At the same time, a clamp section **1333** may operate to keep shorting line **1328'** within a particular range. In particular embodiments, a clamping section **1331** may operate based on a threshold value, turning on when a difference between a shorting line **1328'** potential and bias voltage Vbias2 exceeds such a threshold value. A clamp section **1333** may be dynamic (as in the case of FIG. 13A), being enabled in response to a signal, but may also be static (e.g., always enabled). A clamp section threshold **1333** may be based on any of a number of values, including transistor threshold voltage (Vth), a diode drop voltage, a generated reference voltage, to name but a few.

Referring now to FIG. 13C, another switch circuit that may be included in embodiments is shown in a block schematic diagram and designated by the general reference character **1334"**. A switch circuit **1334'** may include a switch section **1331**, like that of FIG. 13B. A switch circuit **1334"** may include an n-type clamping transistor N13a, a p-type clamping transistor P13a. Clamping transistors (N13a and/or P13a) may have a "diode" connection, and so may conduct when a potential between the source and gate/drain exceeds a threshold voltage. In some embodiments, transistors within a cell group may pull a shorting line **1328"** to a higher potential until a clamping transistor conducts.

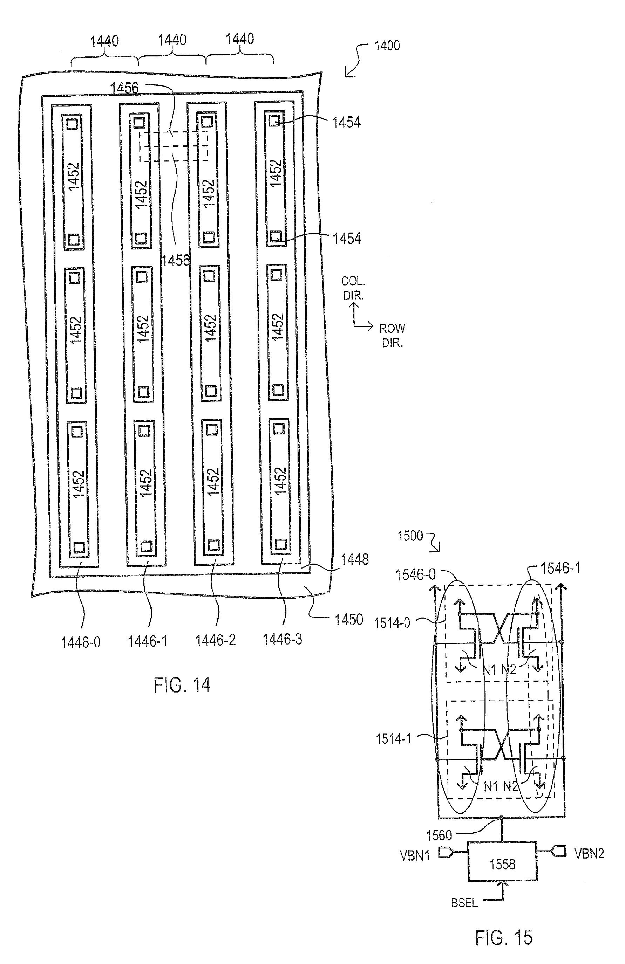

As noted in conjunction with FIG. 5B, in some embodiments, switch circuits, like those shown in FIGS. 15A to 15C, may connect to lines in a row direction. In particular, a cell group may have conductive lines extending in a row direction which may be connected to a bias voltage by switching devices in a first mode. In addition or alternatively, such lines may be connected to clamping devices.

Using diode connected transistors like those of FIG. 13C as clamping devices may enable a clamping range to be "tuned" based on a threshold voltage of such transistors.

As noted above, in some embodiments, groups of memory cells may be switched between modes by biasing bodies of one or more transistors within all memory cells of a cell group. Examples of such embodiments will now be described.

Referring to FIG. 14, one example of a memory device biasing architecture is shown in top plan view and designated by the general reference character **1400**. Architecture **1400** may include a semiconductor substrate **1450** in which may be formed a first well **1448**, and a number of second wells **1446**-0 to -3 formed within first well **1448**. Architecture **1400** may form a substrate for the formation of a memory device having memory cells of different conductivity types. In one particular embodiment, such memory cells may be SRAM cells.

Second wells (**1446**-0 to -3) may have stripe-like shapes, being substantially longer in a memory cell column direction than a row direction. In the embodiment of FIG. 14, each second well (**1446**-0 to -3) may fit within a column pitch **1440** of a memory cell array. Within each second well (**1446**-0 to -3) may be formed active areas **1452**, in which transistor regions (e.g., source, drains, channels) may be formed. FIG. 14 shows three active areas **1452** in each second well (**1446**-0 to -3).

Each active area **1452** may include well taps (two shown as **1454**) for biasing wells and hence biasing the bodies of transistors formed in such wells. In the embodiment of FIG. 14, well taps **1454** may be situated at opposing ends of their respective active areas **1452**. A bias applied to well taps **1454** may be static in some embodiments (with sources of memory cells being biased as described herein, and equivalents). However, in other embodiments, in addition to dynamic source biasing, or as an alternative to dynamic source biasing, different biases may be applied at well taps **1454** to alter memory cell performance.

In one embodiment, a first well **1448** may an n-type well formed in a p-type substrate, and second wells (**1446**-0 to -3) may be p-type wells. In a very particular embodiment, second wells (**1446**-0 to -3) may be "shallow channel" wells. Shallow channel wells will be described in more detail below.

Referring still to FIG. 14, in one embodiment, areas occupied by memory cells may contain portions of adjacent second wells (**1446**-0 to -3). FIG. 14 shows examples of areas **1456** that may be occupied by memory cells.

In this way, a memory device may include wells in a column direction that fit within a column pitch and inlude active areas with separate well taps.

Referring to FIG. 15, a block schematic diagram of a memory device according to another embodiment is shown in a schematic diagram and designated by the general reference character **1500**. A memory device **1500** may include controlling a body bias of transistors in memory cells of a group. In some embodiments, such body biasing may occur in memory cells without corresponding dynamic source biasing. In other embodiments, such body biasing may occur in addition to dynamic source biasing, as described herein and equivalents. In one embodiment, the switchable body biasing of FIG. 15 may be used to drive well taps, like those shown as **1454** in FIG. 14, to thereby alter memory cell performance.

Memory device **1500** may include multiple memory cells **1514**-0/1. Each memory cell may include at least two transistors having bodies connected to different body bias voltages. In the particular embodiment shown, each memory cell **1514**-6/1 may be part of a same column and include two n-channel transistors N1/N2. Transistors N1/N2 may have a cross-coupled configuration with bodies connected to a body bias node **1560**. It is understood that memory cells **1514**-0/1 may include additional transistors (not shown).

As shown in FIG. 15, one transistor in each memory cell (N1) may be formed in one well **1546**-0, while the other transistor in each memory cell (N2) may be formed in a different well.

A body bias switch circuit **1558** may provide one from a number of different body bias voltages to body bias node **1560** in response to a body select value BSEL. In one embodiment, one mode may have a low leakage and slower access speed, while the other may have higher leakage and a higher access speed.

It is understood that other embodiments may include p-channel transistors having bodies switched with a body bias switch circuit.

In this way, a memory device may include memory cells with two transistors formed in different wells having bodies that may be switched to different body bias voltages.

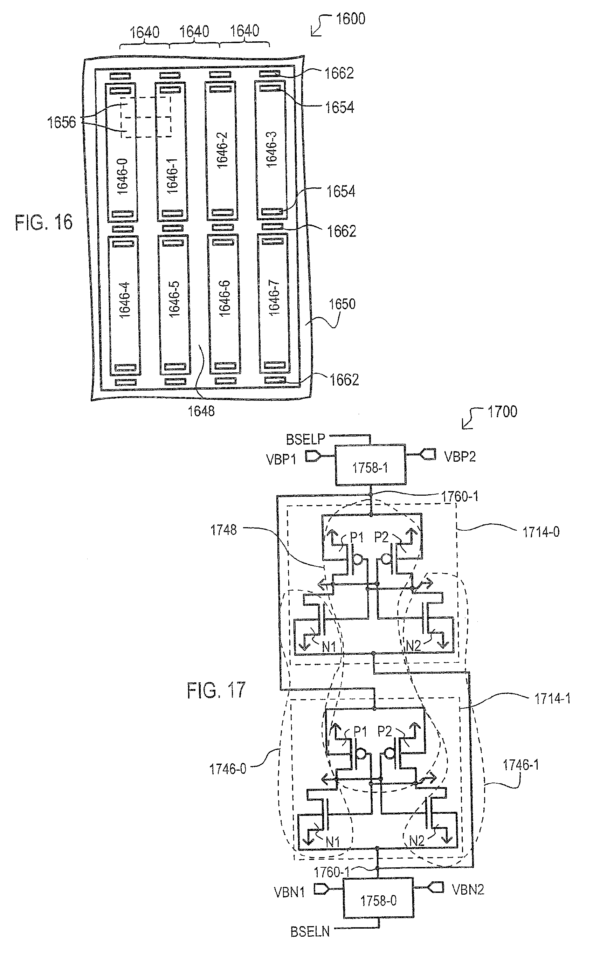

Referring to FIG. 16, another example of a memory device biasing architecture is shown in top plan view and designated by the general reference character **1600**. Architecture **1600** may include a semiconductor substrate **1650** in which may be formed a first well **1648**, and a number of second wells **1646**-0 to -7 formed within first well 1648. Like FIG. 14, architecture **1600** may form a substrate for the formation of a memory device having memory cells of different conductivity types. In one particular embodiment, memory cells may be SRAM cells.

FIG. 16 may include items like those in FIG. 14, and such items are referred to by the same reference character but with the leading digits being "16". Second wells (**1646**-0 to -3) may fit within a column pitch **1640** of a memory cell array.

However, unlike FIG. 14, second wells (**1646**-0 to -7) may not be divided into different active areas. That is, each second wells (**1646**-0 to -7) may include one large active area. Each second well (**1646**-0 to -7) may include second well taps (two shown as **1654**) for biasing such wells. In the embodiment of FIG. 16, second well taps **1654** may be situated at opposing ends of their respective second wells (**1646**-0 to -7).

FIG. 16 also shows first well taps (three shown as **1662**). First well taps (e.g., **1662**) may be situated between and at the ends of second wells (**1646**-0 to -7), in the column direction.

As in the case of FIG. 14, in one embodiment, a first well **1648** may an n-type well formed in a p-type substrate, and second wells (**1646**-0 to -7) may be p-type wells. In a very particular embodiment, second wells (**1646**-0 to -3) may be p-type wells formed in a deep n-well.

Bias voltages applied to first and second well taps (**1654**, **1662**) may be static in some embodiments (with sources of memory cells being biased as described herein, and equivalents). However, in other embodiments one or both such taps (**1654** and/or **1662**) may dynamically bias their respective wells to alter memory cell leakage and/or performance.

Referring to FIG. 17, a block schematic diagram of a memory device according to another embodiment is shown in a schematic diagram and designated by the general reference character **1700**. A memory device **1700** may include controlling body biases for two different types of transistors in the memory cells. In some embodiments, such body biasing may occur in memory cells without corresponding source biasing. In other embodiments, such body biasing may occur in addition to source biasing, as described herein and equivalents.

Further, it is understood that there may be a difference in granularity with respect to source biasing and body biasing. For example, a group of cells that may have source biasing, may be a subset or superset of a different group of cells that have body biasing. Still further, a group of source biased cells may only partially overlap a group of body biased cells.

Memory device **1700** may include multiple memory cells **1714**-0/1. Each memory cell may include two or more transistors of a first conductivity type, and two or more transistors of a second conductivity type. The bodies of each different type of transistor may be driven between at least two body bias voltages. In the particular embodiment shown, each memory cell **1714**-0/1 may be part of a same column and include two n-channel transistors N1/N2, and two p-channel transistors P1/P2, both pairs having a cross-coupled configuration. Transistors N1/N2 may have bodies connected to a first body bias node **1760**-0, while transistors P1/P2 may have bodies connected to a second body bias node **1760**-1. It is understood that each of memory cells **1714**-0/1 may include additional transistors (not shown).

As shown in FIG. 17, one transistor in each memory cell (N1) may be formed in one well **1746**-0, while the other transistor in each memory cell (N2) may be formed in a different well **1746**-1. Further, p-type transistors P1/P2 of the memory cells **1714**-0/1 may be formed in a same well **1748**.

A first body bias switch circuit **1758**-0 may provide one from a number of different body bias voltages to first body bias node **1760**-0 in response to a first body select value BSELN. A second body bias switch circuit **1758**-1 may provide one from a number of different body bias voltages to second body bias node **1760**-1 in response to a second body select value BSELP.

In one embodiment, different body bias voltages may be applied to transistors within memory cells to provide two or more different modes, each having a different current leakage and/or and access speed.

In this way, a memory device may include memory cells with different transistor conductivity types formed in different wells, each such well being switched between different body bias voltages.

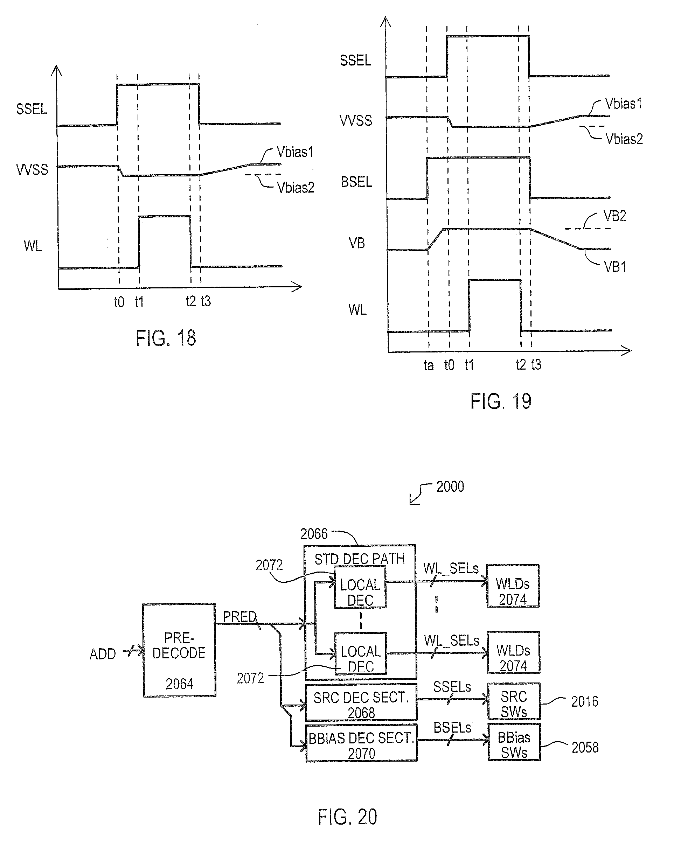

Embodiments above have shown dynamic source biasing networks, in which a different source bias voltages may be applied to sources of memory cells in one group. One example of a source bias switching operation is shown in a timing diagram of FIG. 18. In particular arrangements, FIG. 18 may correspond to operations of source switching circuits shown herein, and equivalents.

FIG. 18 includes waveforms SSEL, VVSS and WL. Waveform SSEL may correspond to a source select signal that may switch a source bias voltage for a group of memory cells. Waveform VVSS may correspond to a source potential applied on a source bias network. Waveform WL may correspond to a word line of an accessed row within the group of memory cells.

Prior to time t0, SSEL and WL may both be inactive (low in this example).

Consequently, VVSS may be at a first source bias voltage (Vbias1), placing memory cells in a first mode. In the embodiment shown, VVSS may be applied to sources of n-channel transistors and Vbias1 may be higher in potential than Vbias2, and thus may place memory cells in a low leakage and/or lower performance mode. In other embodiments, VVSS may correspond to p-channel transistors, and Vbias1 may be less than Vbias2.

At about time t0, SSEL may transition to an active level (high in this example). As a result, VVSS may be driven at a relatively rapid rate to Vbias2, switching transistors of the correspond cell group (and not other cell groups) from one mode to another.

At about time t1, after VVSS has been switched to Vbias2, WL may transition to an active level (high in this example). As a result, a row of memory cells within the group (now biased to Vbias2) may be accessed for a read or write operation.

At about time t2, WL may return to an active level.

At about time t3, after WL has returned to an inactive level, SSEL may return to an inactive level. As a result, VVSS may return to the Vbias1 level, switching transistors of the group to the initial bias conditions. In the embodiment shown, VVSS may return to Vbias1 from Vbias2 at a slower rate than it transitions from Vbias1 to Vbias2.

Embodiments above have also shown source biasing networks used in conjunction with body biasing arrangements. One embodiment showing such a combination approach is shown in a timing diagram of FIG. 19. The body biasing shown in FIG. 19 may correspond to operations of body bias switching circuits shown herein, and equivalents.

FIG. 19 includes waveforms SSEL, VVSS, and WL as shown in FIG. 18. In the embodiment shown, such waveforms may occur in the same fashion as FIG. 18. Accordingly, a description of such waveforms is omitted.

FIG. 19 also includes a waveform BSEL corresponding to a body bias select signal that may switch a body bias voltage for a group of memory cells, and a waveform VB corresponding to a body bias potential applied to transistors of the cell group.

Prior to time t0, BSEL may be inactive (low in this example). Consequently, VB may be at a first body bias voltage VB1, placing memory cells in a first mode. In one embodiment, VB1 may be applied to bodies of n-channel transistors and Vbias1 may be lower in potential than Vbias2, and thus may place memory cells in a low leakage and/or lower performance mode. In other embodiments, VB1 may correspond to bodies of p-channel transistors, and VB1 may be greater than VB2.

At about time ta, prior to SSEL being activated at time t0, BSEL may transition to an active level (high in this example). As a result, VB may be driven at a relatively rapid rate to bias VB2, switching transistors of a group from one mode to another.

At about time t3, after WL has returned to an inactive level, BSEL may return to an inactive level. As a result, VB may return to the VB1 level, switching transistors of the group to the initial level.

It is noted that while the embodiments of FIGS. 18 and 19 have shown waveforms transitioning in particular sequences, other embodiments may include different timings of such transitions. As but one example, signals SSEL, WL, and BSEL may transition substantially at the same time.

Still further, in some embodiments, a source select signal SSEL may be the same as a body bias select signal BSEL.

In embodiments shown above, groups of memory cells may switch between modes by controlling source switching circuits and/or body bias switch circuits. In some embodiments, such circuits may be controlled in response to a decoded address. Further, a decoding path for activating source switching or body bias switching may be faster than decode paths for accessing memory cells (such as decode paths to word lines). A particular embodiment showing such a decoding arrangement is shown in FIG. 20.

Referring now to FIG. 20, a decoding circuit according to an embodiment is shown in block schematic diagram and designated by the general reference character **2000**. A decoding circuit **2000** may include a pre-decode section **2064** and a standard decode section **2066**. Decoding circuit **2000** may also include a "fast" source decode section **2068** and/or a "fast" body bias decode section **2070**. It is understood that in embodiments having only dynamic source switching, a body bias decode section **2070** may not be included. Similarly, in embodiments having only dynamic body bias switching, a source decode section **2068** may not be included.

A pre-decode section **2064** may receive address values (ADD), and in response, activate pre-decode signals PRED. In the embodiment shown, pre-decode signals PRED may be applied to standard decode section **2066**, applied to "fast" source decode section **2068** (if included), and applied to "fast" body bias decode section **2070** (if included).

Standard decode section **2066** may include local decoders **2072** that activate particular word line select signals (WL_SEL) according to pre-decode signals PRED. In response to word lines select signals WL_SEL, a word line may be activated by a word line driver circuit **2074**.

Source decode section **2068** may receive pre-decode signals PRED and provide source select signals (SSELs_. Source decode section **2068** may activate one or more source select signals (SSELs), but not all such source select signals according to pre-decode signals PRED. A source decode section **2068** may provide a faster decode operation than standard decode section **2066**, activating a source select signal(s) before a word line is activated. It is noted that source decode section **2068** may receive different pre-decode signals than standard decode section **2066**, or a subset of the pre-decode signals received by standard decode section **2066**. When activated, each source select signal (SSELs) may activate a corresponding one of source switches **2016**.

In a similar fashion, body bias decode section **2070** may receive pre-decode signals PRED and provide body bias select signals (BSELs). Body bias decode section **2070** may activate one or more body bias select signals (BSELs), but not all such source select signals, according to pre-decode signals PRED. As in the case of the source decode section **2068**, body bias decode section may provide a faster decode operation than standard decode section **2066**. Body bias decode section **2070** may also receive different pre-decode signals than standard decode section **2066**. When activated, each body bias select signal (SSELs) may activate a corresponding one of body bias switches **2058**.

In this way, a memory device may include a source select decode path and/or body bias decode path that is faster than a standard decode path for a word line, or the like.

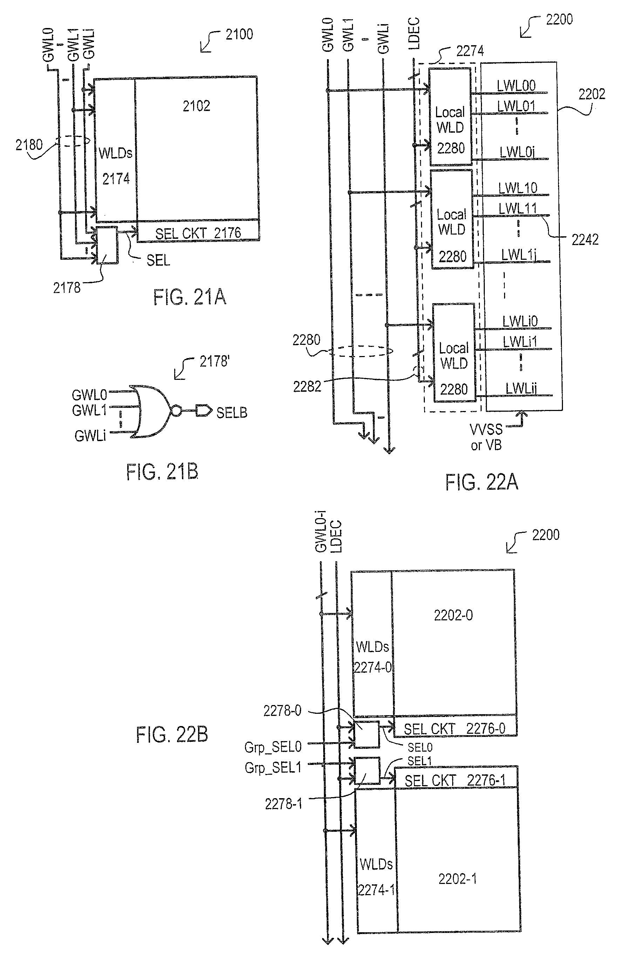

While selection signals for applying source and/or bias voltages may be generated in various ways, in particular embodiments "global" word lines signals may be utilized to generate source bias and/or body bias select signals. A particular embodiment showing such a selection arrangement is shown in FIG. 21A.

Referring now to FIG. 21A, a memory device according to one embodiment is shown in block schematic diagram and designated by the general reference character **2100**. A memory device **2100** may include a memory cell group **2102**, word line drivers **2174**, select circuits **2176**, and select logic **2178**.

A memory cell group **2102** may include memory cells arranged into multiple rows, each row being accessed by activation of a corresponding local word line. In addition, memory cells of memory cell group **2102** may each have a source connection and/or a body connection to enable all memory cells to be dynamically biased together.

Word line drivers **2174** may receive global word lines signals (GWL0 to GWLi) on global word lines **2180**. Each global word line signal (GWL0 to GWLi) may select a set of local word lines.

Select circuits **2176** may apply different bias voltages to memory cells of cell group **2102** in response to a select signal SEL. In some embodiments, select circuits **2176** may include source switch circuits, body bias switch circuits, or combinations thereof as shown in other embodiments, or equivalents.

Select logic **2178** may generate select signal SEL in response to global word line signals (GWL0 to GWLi).

FIG. 21B shows one very particular example of select logic **2178**' that may be included in embodiments. Select logic **2178**' may be one implementation of that shown as **2178** in FIG. 21A. Select logic **2178**' may logically NOR (or perform an equivalent action) global word lines signals (GWL0 to GWLi) to generate a select signal SELB. In such an arrangement, if any global word line (GWL0 to GWLi) is activated, select signal SELB may be activated.

In this way, source bias switches and/or body bias switches may be activated in response to a logical combination of global word line signals.

While the embodiment of FIG. 21A shows an embodiment in which global word lines (GWLs) have a smaller granularity than a cell group, in other embodiments there may be a different granularity. As but one example, global word lines may have the same granularity as a cell group. In such an embodiment, a global word line signal may act as, or be the source of, a select signal SEL (or SELB).

Referring now to FIGS. 22A and 22B, a memory device according to an alternate embodiment is shown in block schematic diagram and designated by the general reference character **2200**.

Referring to FIG. 22A, a portion of memory device **2200** may include a memory cell group **2202** and a word line decoder circuit **2274**. Memory cell group **2202** may include memory cells arranged into multiple rows, each accessed by a local word line (one shown as **2242**. Memory cells within cell group **2202** may receive a bias voltage, which may be a source bias voltage WSS, a body bias voltage VB, or both. A bias voltage (VVSS and/or VB) may be applied by a select circuit (not shown in FIG. 22A, but shown in FIG. 22B).

A word line decoder circuit **2274** may include a number of local word line driver circuits (one shown as **2280**). Each local word line driver (e.g., **2280**) may be connected to a set of corresponding local word lines (LWL00 to LWL0j, LWL10 to LWL1j, etc.), and may receive one global word line signal (GWL0 to GWLi) and local decoding signals LDEC. In response to such inputs, a local word line driver (e.g., **2280**) may activate one word line of its corresponding set.

Referring to FIG. 22B, a memory device **2200** may include multiple memory cell groups **2202**-0/1 and corresponding word line decoder circuits **2274**-0/1 having the form shown in FIG. 22A. In addition, a select circuit **2276**-0/1 and group select logic **2278**-0/1 may be provided for each memory cell group **2202**-0/1.

Select circuits **2276**-0/1 may apply different bias voltages to memory cells of their corresponding cell group **2202**-0/1 in response to a select signals SEL0 and SEL1, respectively. As in the case of FIG. 21A, in some embodiments, select circuits **2176**-0/1 may include source switch circuits, body bias switch circuits, or combinations thereof as shown in other embodiments, or equivalents.

Unlike FIG. 21, in the embodiment of FIG. 22B, global word lines signals are not used to generate select signals SEL0/1. Instead, group select signals Grp_SEL0/1 may be provided that are separate from global word line signals (GWL0 to -i).

Group select logic **2278**-0/1 may generate select signals SEL0/1 in response to corresponding group select signals Grp_SEL0/1 and local decoder signals LDEC.

In this way, source bias switches and/or body bias switches may be activated in response to groups select signals corresponding to memory cell groups and local decoder information.

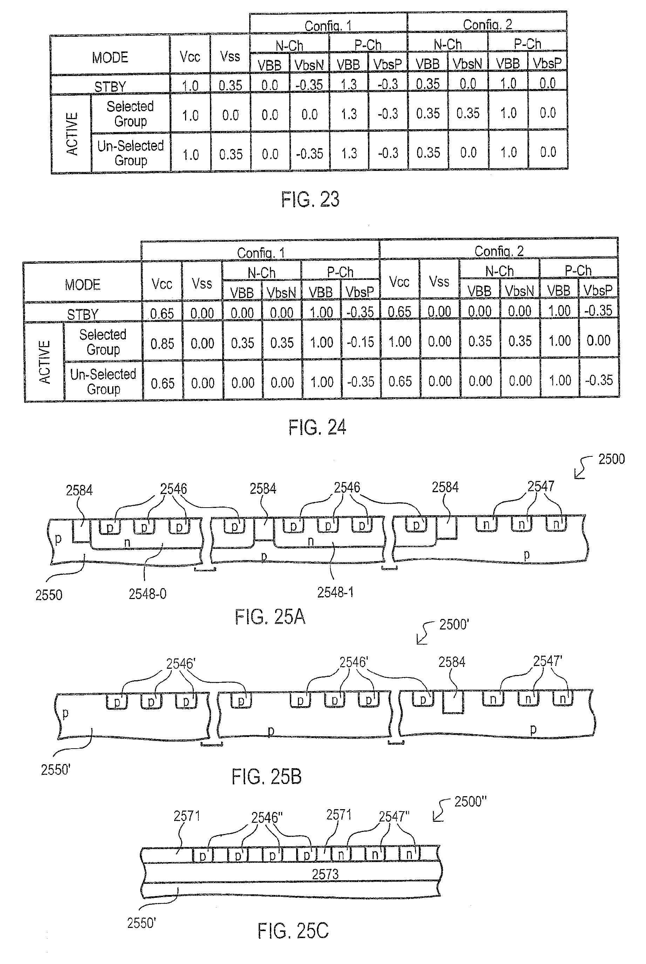

Referring now to FIG. 23, a table shows possible bias voltages for a memory cell group according to one embodiment. FIG. 23 shows a biasing arrangement for memory cells having a configuration like that shown in FIG. 13A (e.g., 6-T memory cell), in which dynamic source biasing (and static body biasing) occurs. Numerical values are given in volts.

As shown in the table, a memory device may be conceptualized has having two modes: standby (STBY) and ACTIVE. In a mode STBY, memory cells are not accessed, and may draw a low value current as compared to the ACTIVE mode. In the ACTIVE mode, for a selected cell group (i.e., a memory cell group having cells that are accessed), a source voltage (Vss) may be lowered from +0.35V to 0.00 V.

FIG. 23 shows two possible configurations, each showing biasing for both an n-channel transistor (N-Ch) and a p-channel transistor (P-Ch). Each configuration shows VBB (a body bias voltage) and VbsN/P (a body bias with respect to the source).

Referring now to FIG. 24, another table shows possible bias voltages for a memory cell group according to a further embodiment. FIG. 24 also shows a biasing arrangement for memory cells having a configuration like that shown in FIG. 13A, however, the values represent dynamic body biasing (while sources have static biasing). Numerical values are given in volts. The various columns have the meanings as noted in FIG. 24.

It is understood that FIGS. 23 and 24 are but exemplary biasing conditions, and other embodiments may include different voltages with a same general relational (greater than, less than) difference. Further, in embodiments having both dynamic source biasing and dynamic body biasing, one skilled in the art would understand such biasing values would be selected to avoid forward biasing source-body p-n junctions.

Referring now to FIG. 25A, a substrate structure that may be included in the embodiments is represented in a side cross sectional view, and designated by the general reference character **2500**. Structure **2500** includes a substrate **2550** in which may be formed first wells **2548**-0/1 and second wells **2546**. First wells **2548**-0/1 may be separated from one another in a lateral direction (e.g., parallel to a top surface) by isolation structures **2584**.

In one embodiment, a different memory cell group may be formed in each first well **2548**-0/1. Further, each second well **2546** may contain one or more transistors of memory cells of the cell group. In one particular embodiment, each second well **2546** may include transistors from memory cells of a same column.

First wells **2548**-0/1 and/or second wells **2546** may have well taps (not shown), to enable such wells to be dynamically biased as described in other embodiments herein, and equivalents.

The structure of FIG. 25A may be used to form memory cell groups as shown in the embodiments herein. As but one example, a substrate **2550** may be a p-type substrate, first wells **2548**-0/1 may be "deep" n-wells that contain p-channel transistors of memory cells. Such deep wells may extend beyond isolation structures **2584**. Second wells **2546** may be p-wells that contain n-channel transistors of memory cells.

The particular embodiment of FIG. 25A also shows third wells **2547**, which may be n-wells formed in substrate **2550**, in which may be formed n-channel transistors.

FIG. 25A shows a "triple well" type substrate structure. However, other embodiments may be formed with a dual well type structure, like that shown in FIG. 25B. Referring to FIG. 25B, structure **2500**' may include a substrate **2550**' in which may be formed first wells **2546**' and second wells **2547**'. Each first well **2546**' may contain one or more transistors of memory cells of the cell group. In one particular embodiment, each second well **2547**' may include transistors of a different conductivity type.

Substrate **2550**' and/or second wells **2547**' may have taps (not shown), to enable bodies of corresponding transistors be dynamically biased as described in other embodiments herein, and equivalents.

FIG. 25C shows yet another structure that may be utilized to form memory cell groups. FIG. 25C shows a silicon on insulator structure **2500**". First wells **2546**" and second wells **2547**" may be formed on a substrate insulating layer **2573**, and be separated from one another in a lateral direction by isolation structures **2571**. Each first well **2546**" may contain one or more transistors of memory cells of the cell group, while second wells **2547**" may contain transistors of an opposite conductivity type. A structure **2500**" like that of FIG. 25C may have various biasing arrangements. In one embodiment, source biasing may occur with a dynamic source biasing network as described herein, and equivalents. Such a dynamic source biasing embodiment may have floating bodies (i.e., wells **2546**" and/or **2547**" are not biased), or static biasing (i.e., wells **2546**" and/or **2547**" have taps to unchanging bias voltages), or dynamic body biasing (i.e.,

wells **2546"** and/or **2547"** have taps and are driven between two or more body bias voltages). In still other embodiments there may be no source biasing, but only dynamic body biasing.

While embodiments of the invention may be formed in a substrate structure like that shown in FIG. 25A to 25C, as noted above, other embodiments may form memory cells all, or in part, with "shallow' wells. Examples of shallow well structures will now be described.

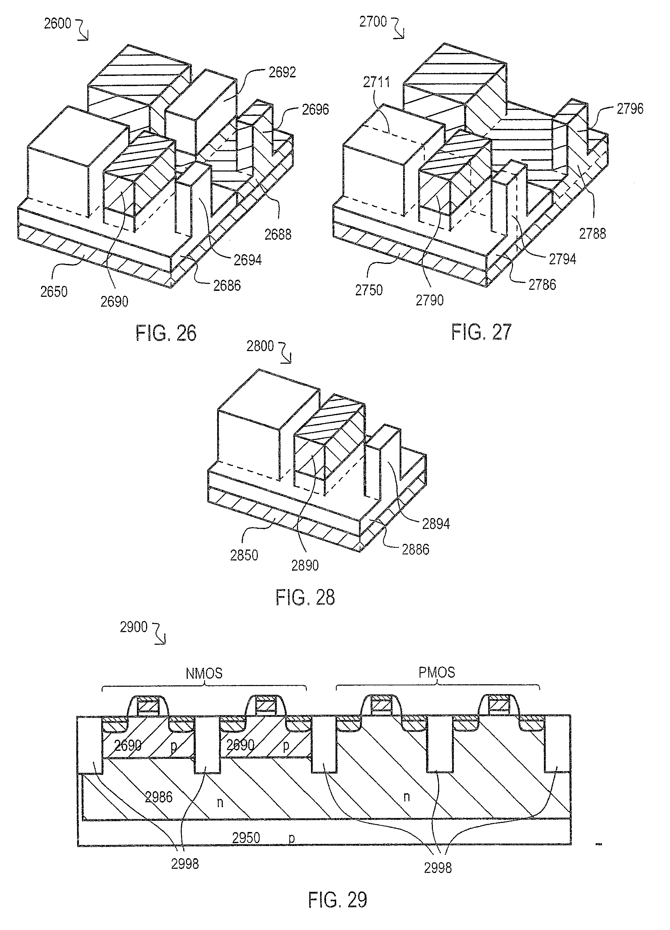

Referring to FIG. 26, an alternate substrate structure is shown in perspective view, and designated by the general reference character **2600**. Structure **2600** may include a substrate **2650**, in which may be formed a first type deep well **2686**, a second type deep well **2688**, a first type shallow well **2690**, and a second type shallow well **2692**. It is understood that isolation structures may be formed between the various wells in a lateral direction. A first type deep well **2686** may be biased by a first well tap **2694**. Similarly, a second type deep well **2688** may be biased by a second well tap **2696**.

In the embodiment shown, isolation structures (open lateral spaces in FIG. 26), may extend further into a surface than shallow wells (**2688** and **2690**).

A substrate structure **2600** may be used to form a memory device as shown in embodiments herein. As but one example, different conductivity type memory cell transistors may be formed in shallow wells (**2690** and **2692**). Such shallow wells (**2690** and **2692**) may have static biasing or dynamic biasing to provide body biasing as described for embodiments herein, and equivalents. In some embodiments, at the same time, non-memory cell transistors of a memory device (e.g., input/output driver transistors, logic circuit transistors, etc.) may be formed in deep wells (**2686** and **2688**).

It is understood that the structure **2600** of FIG. 26 is representational, as a memory device may include multitude of such wells occupy areas of appropriate sizes according to the device design.

In this way, a memory device may include memory cell groups with source and/or body biasing, where such memory cells have shallow well transistors.

While the embodiment of FIG. 26 shows a structure that may allow for four different types of memory cells, other embodiments may include fewer such types. FIGS. 27 and 28 show arrangements that allow for fewer than four different types of memory cells. Such structures may include items like those shown in FIG. 26, and such like items are referred to by the same reference characters but with the first two digits corresponding to the figure number.

FIG. 27 shows a structure **2700** that may have memory cells with transistors of one conductivity type being formed in one shallow well **2790**. Memory cell transistors of another conductivity type may be formed in deep well **2788**.

FIG. 28 shows a structure **2800** that may have transistors of one conductivity type being formed in shallow wells **2890**. Memory cell transistors of another conductivity type may be formed in deep wells **2850**.

Referring now to FIG. 29, a further substrate structure that may be included in the embodiments is represented in a side cross sectional view, and designated by the general reference character **2900**. Structure **2900** may show one implementation of that shown in FIG. 27, and may occur along plane **2711** shown in FIG. 27.

A structure **2900** may include a p-type substrate **2950** in which may be formed a blanket n-well **2986** and shallow p-wells **2690** within the blanket n-well **2986**. An n-well **2986** may be considered a "blanket" n-well as it may be formed without masking out particular regions for different transistor types. In one embodiment, such a blanket n-well may form a memory cell formation region.

Within blanket n-well **2986**, shallow p-wells **2690** may be separated from one another by isolation structures **2998**. Shallow p-wells **2690** may not extend into substrate **2950** further than isolation structures **2998**.

Referring still to FIG. 29, shallow p-wells **2690** may include n-channel MOS type transistors, more particularly, may include NMOS pull-down and access transistors of a 6-T SRAM cell. Blanket n-well **2986** may include p-channel MOS type transistors, more particularly, PMOS pull-up transistors of a 6-T SRAM cell.

Sources of NMOS and/or PMOS transistors may be dynamically biased as described herein, or equivalents. In addition or alternatively, shallow p-wells **2690**-0/1 and/or shallow n-wells **2692** may be dynamically biased to provide body switching as described herein and equivalents.

In this way, an SRAM device having source and/or body bias switching may include memory cells with transistors of n-channel and p-channel types formed in shallow wells.

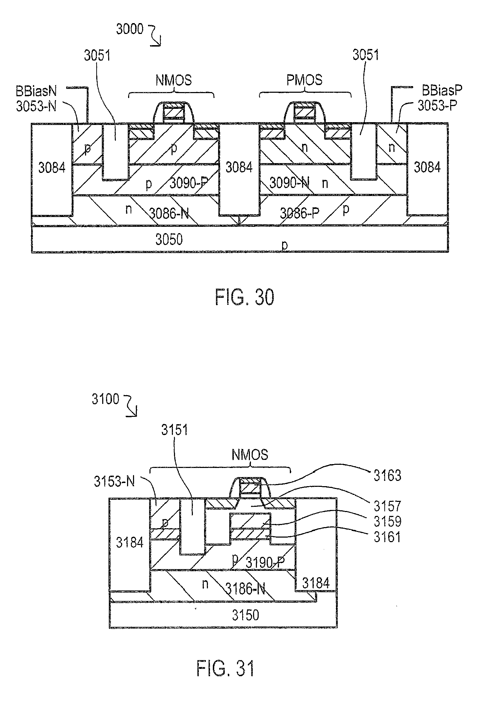

Referring now to FIG. 30, a further substrate structure that may be included in the embodiments is represented in a side cross sectional view, and designated by the general reference character **3000**.

A structure **3000** shows transistors formed with "partial trench isolation" techniques. While FIG. 30 shows the formation of both an n-channel transistor **3055**-N and a p-channel transistor **3055**-P, it is understood that embodiments may include this type of structure for only one transistor conductivity type.

A structure **3000** may be formed in a substrate **3050**, which in this embodiment, may be p-type substrate. Within substrate **3050** may be formed an n-well **3086**-N for containing one or more n-channel devices, as well as a p-well **3086**-P for containing one or more p-channel devices. N-well 3086-N may be separated from p-well **3086**-P by shallow trench isolation (STI) structures **3084** that extend into a substrate, and terminate within such wells, as shown. A shallow p-well **3090**-P may be formed within n-well **3086-**N. Similarly, a shallow n-well **3090**-N may be formed within p-well **3086**-P. Shallow n- and p-wells (**3090**-N/P) may extend into substrate **3050**, but terminate at a depth shallower than STI structures **3084**.

Referring still to FIG. 30, structures within shallow n- and p-wells (**3090**-N/P) may be separated from one another by partial trench isolation (PTI) structures **3051**. In the particular example shown, n-channel transistor **3055**-N may be separated from a body contact region **3053**-N by one PTI structure **3051** while p-channel transistor **3055**-N may be separated from a body contact **3053**-P by another PTI structure **3051**. However, it is understood that PTI structures (e.g., **3051**) may also separate like transistors formed in a same shallow well. As but one example, multiple n-channel transistors (e.g., **3055**-N) may be formed in shallow p-well **3090**-P, and separated from one another by PTI structures (e.g., 3051).

Body bias voltages (shown as BbiasN and BbiasP) may be applied to transistors by way of the corresponding body contact 3053-P/N. According to an STI arrangement, such body contacts **3053**-P/N may apply body biases to one or more devices. In particular, devices of a same shallow well may have common body biasing via one or more body contacts to the shallow well. Body bias voltages may be static, or may be dynamic as described herein and equivalents.

In this way, devices according to embodiments may have dynamic source and/or body biasing of transistors with partial trench isolation structures.

Referring now to FIG. 31, one very particular example of a PTI substrate structure is shown in a side cross sectional view, and designated by the general reference character **3100**'. Structure **3100**' shows a "deeply depleted channel" (DDC) type transistor structure. While structure **3100**' shows an n-channel transistor structure, a corresponding p-channel structure would be readily understood by those skilled in the art, by suitable reversing conductivity types.

FIG. 31 includes many sections like those of FIG. 30. Such like sections are referred to by the same reference characters, but with the first digits being "31" instead of "30".

FIG. 31B shows how a DDC type transistor structure may include channel region **3157**, an optional threshold voltage tuning region **3159**, and a relatively highly doped screening region **3161**. A channel region **3157** may have a relatively low concentration of p-type dopants as compared to other body regions, or may be undoped with respect to p-type dopants (A channel region may or may not include stress inducing elements). A threshold voltage tuning region **3159**, if included, may have doping levels suitable to achieve a desired transistor threshold voltage characteristic. Screening region **3161** may have a relatively high doping concentration of p-type elements, as compared to channel region **3157**. A channel depth, measured from gate structure **3163** may be deeper than typical transistor designs, and in particular embodiments, may have a depth in the range of about 5 to 50 nanometers. In other embodiments, a channel depth may be in the range of about 1/3 to ½ of a gate length of the corresponding transistor.

In operation a body bias voltage may be applied at body contact region **3153**-N. A DDC type structure may provide for accurate control and modulation of a transistor threshold voltage.

In this way, devices according to embodiments may have dynamic source and/or body biasing of DDC type transistors.

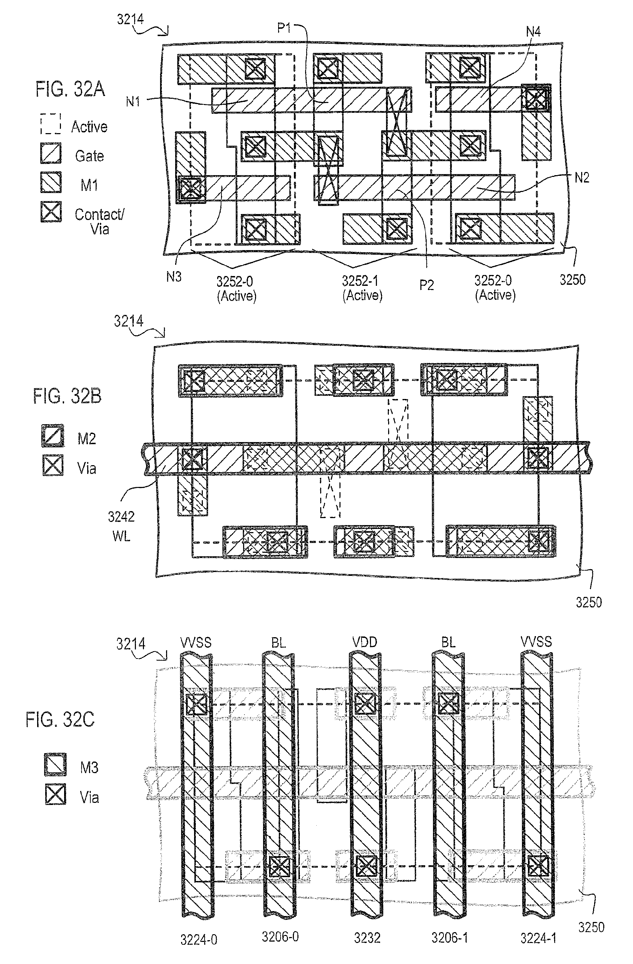

Referring now to FIGS. 32A to 32C, a memory cell and formation method according to one embodiment are shown in a series of plan views. FIGS. 32A to 32C show the formation of a 6-T SRAM memory cell like that shown in FIG. 13A and identified as **1314**-0 or -1. Accordingly, like items are referred to by the same reference character but with the first digits being "32" instead of "13".

FIG. 32A shows active areas, a gate layer, a first metallization layer M1, and contacts and vias, as understood from the legend.

Referring to FIG. 32A, an SRAM cell **3214** may include two n-channel transistor active regions 3252-0 formed in a substrate **3250**. In between such active regions **3252**-0 may be a p-channel transistor active region **3252**-1. Access transistor N3 and pull-down transistor N1 may be formed in one active region **3252**-0, while access transistor N4 and pull-down transistor N2 may be formed in the other active region 3252-0. Pull-up transistors P1/P2 may be formed in active region **3252**-1.

FIG. 32B shows a second metallization layer M2 and corresponding vias, as understood from the legend. In FIG. 32B, a word line **3242** may be formed in a M2 layer and connected to gates of transistors N3/N4 via first metallization layer M1. It is understood that word line **3242** may be connected to a row of memory cells in like manner. Second metallization layer M2 may also create landing locations for source connections to transistors N1/N2 (via layer M1), source connections to transistors P1/P2 (via layer M1). and drain connections to access transistors (via layer M1).

FIG. 32C shows a third metallization layer M3 and corresponding vias, as understood from the legend. In FIG. 32C, a layer M3 may form a first source bias line **3224**-0, which may connect to a source of transistor N1 via intervening layers M2/M1, and second source bias line **3224**-1, which may connect to a source of transistor N2 via intervening layers M2/M1. Further, a layer M3 may form a first bit line **3206**-0, which may connect to a drain of transistor N3 via intervening layers M2/M1, and a second bit line **3206**-1, which may connect to a drain of transistor N4 via intervening layers M2/M1. Still further, layer M3 may form a power supply line **3232** which may connect to the sources of transistors P1/P2 via intervening layers M2/M1.

It is understood that source bias lines **3224**-0/1, bit lines **3206**-0/1 and power supply line **3232** may be connected to a column of memory cells in a like fashion.

In this way, a 6T memory cell may include a first pull-down transistor having a source connected to one source bias line common to a column, and a second pull-down transistor having a source connected to a different source bias line also common to the column.

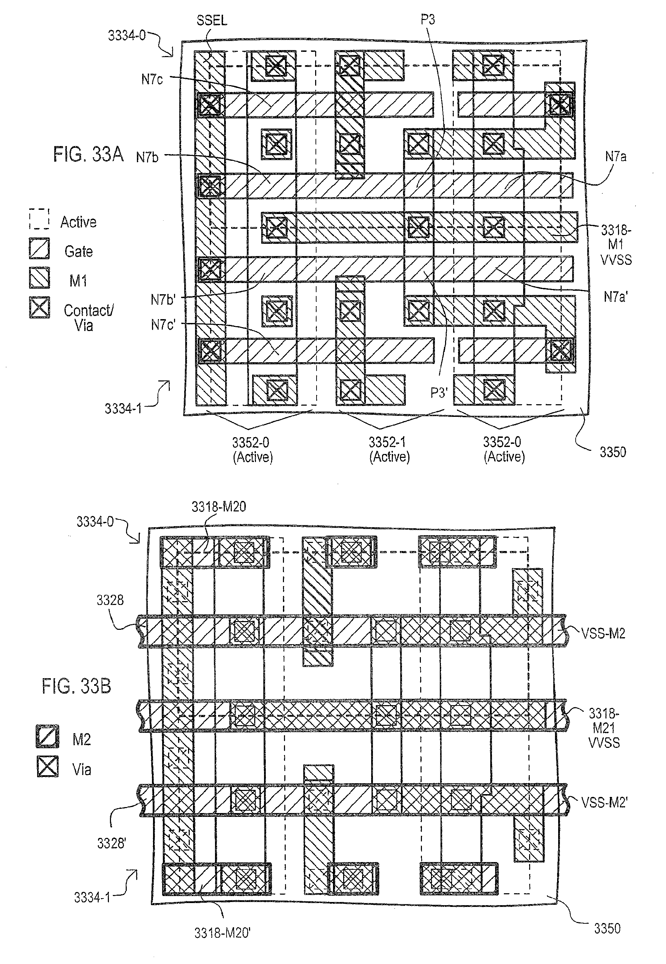

Referring now to FIGS. 33A to 33C, a switch element and formation method according to one embodiment are shown in a series of plan views. FIGS. 33A to 33C show the formation of two switch elements like those shown in FIG. 13A as item **1334**-0 or -1. Accordingly, like items are referred to by the same reference character but with the first digits being "33" instead of "13". Further, items in one switch element **3334**-1 are distinguished from those of the other switch element **3334**-0 by a "prime" symbol (apostrophe). In the embodiment shown, switching a source biasing network to a bias voltage VSS may be accomplished with three transistors N7a1b/c. That is, in FIG. 33A transistors N7a/b/c may correspond to transistor N7 in FIG. 13A.

It is noted that switch elements **3334**-0/1 may be connected to a memory cell **3214** shown in FIGS. 32A to 32C. Further switch elements **3334**-0/1 may fit within the same pitch as memory cell **3214** and have similar diffusion pattern.

FIG. 33A shows active areas, a gate layer, a first metallization layer M1, and contacts and vias, as understood from the legend. FIG. 33A shows two n-chancel transistor active regions **3352**-0 formed in a substrate **3350**. In between such active regions **3352**-0 may be a p-channel transistor active region **3352**-1. Switch transistors N7b/b' and N7c/c' may be formed in one active region **3352**-0, while switch transistors N7a/a' and limit transistors may be formed in the other active region **3352**-0. Clamp transistors P3/3' may be formed in active region **3352**-1. First metallization layer M1 may include a structure **3318**-M1 that conductively connects drains of transistors N7a/b/a'/c' to one another. Accordingly, structure **3318**-M1 may form part of shorting line for a source biasing network. FIG. 33A also includes a select line SSEL. A select line SSEL may be connected to gates of transistors N7a/b/c/a'/b'/c', to thereby enable switch elements **3334**-0/1.

FIG. 33B shows a second metallization layer M2 and corresponding vias, as understood from the legend. In FIG. 33B, structures **3318**-M20/0' and **3318**-M21 may form further portions of a shorting line of a source bias network. In addition, two structures VSS-M2 may be bias supply lines for providing VSS to the source bias network. It is understood that lines **3318**-M21 and lines VSS-M2 may be connected to a row of switch elements in a like manner.

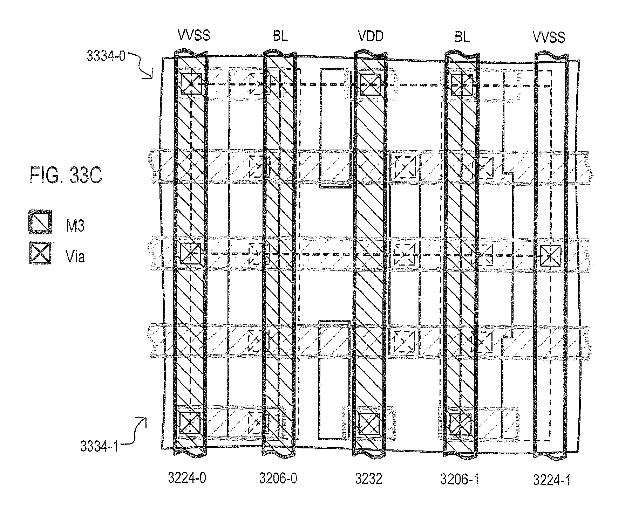

FIG. 33C shows a third metallization layer M3 and corresponding vias, as understood from the legend. In FIG. 33C, a layer M3 follow that shown in FIG. 32C, including first and second source bias line **3224**-0/1, which may connect switch transistors N7a/b/c/a'/b'/c' via intervening layers M2/M1. Further, bit line **3206**-1 may connect to limit transistor via intervening layers M2/M1. Still further, power supply line **3232** may connect to clamp transistors P3/3' via intervening layers M2/M1.

In this way, switch elements may connect a source biasing network to a bias supply voltage.

While the embodiment of FIGS. 33A to 33C show particular lines formed with particular metallization layers, such an arrangement should not be construed as limiting. In one very particular alternate embodiment, column direction lines, like those shown in FIG. 33C could be realized in a metallization layer lower than the row direction lines, like those shown in FIG. 33B. In a very particular embodiment, such column direction lines could be realized in a layer M2, while row direction lines could be realized in a layer M3.

It is understood that memory devices as shown herein, and equivalents may form an embedded memory in a larger integrated circuit and/or a standalone memory device.

Still further, while the various embodiments have shown transistors arranged into memory cells, other embodiments may include different circuit types with transistors having sources and/or bodies dynamically biased as described herein. As but one example, alternate embodiments may include groups of logic cells formed with transistors in place of, or in addition to, memory cells, where such logic cell groups may be separately operated in two or more different modes with dynamic source and/or body biasing. Such logic cells may be connected to one another with metallization layers, a portion of which may form a source bias network and/or connections to drive well taps.

As another embodiment, custom logic may be designed having a source bias network and/or body bias connections as described herein. Such custom logic may be broken into sections that dynamically biased.

In still another embodiment, a programmable logic device may have programmable logic circuit groups with transistors having dynamic source and/or body biasing as described herein. In a very particular programmable logic embodiment, such dynamically biased programmable logic transistors may be formed in conjunction with memory cells as described herein, with memory cells storing configuration data for establishing the operation of the programmable logic transistors.

It should be appreciated that in the foregoing description of exemplary embodiments of the invention, various features of the invention are sometimes grouped together in a single embodiment, figure, or description thereof for the purpose of streamlining the disclosure aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

It is also understood that the embodiments of the invention may be practiced in the absence of an element and/or step not specifically disclosed. That is, an inventive feature of the invention may be elimination of an element.

Accordingly, while the various aspects of the particular embodiments set forth herein have been described in detail, the present invention could be subject to various changes, substitutions, and alterations without departing from the scope of the invention.

Various further aspects and features of the present invention are defined in the appended claims. Various combinations of features of the dependent claims may be made with the independent claims in combination other than those explicitly recited in the claim dependency of the appended claims.

**Claims**

1. An integrated circuit device, comprising:

   a plurality of memory cells arranged into groups formed in a semiconductor substrate, each group having a plurality of rows and columns, each memory cell having at least a first bias connection;
   a biasing network for each group that includes a plurality of first conductive lines disposed in the column direction having conductive connections to the bias connections of its group and not adjacent groups; and
   a different source switch coupled to each biasing network that selectively applies at least one bias voltage to the memory cells of the group to alter leakage characteristics of such memory cells.

2. The integrated circuit of claim 1, wherein:

   the biasing network for each group further includes at least one second line disposed in the row direction conductively connected to each first conductive line of the corresponding group.

3. The integrated circuit of claim 1, wherein:

   the biasing network includes at least one first conductive line coupled to each column of the corresponding group.

4. The integrated circuit of claim 1, wherein:

   at least one group is separated from an adjacent group in the directions of the columns by a group separation region;
   the first conductive lines of the one group and the adjacent group are separated from one another by the separation region; and
   a plurality of bit lines extend over the separation region and couple memory cells of a column in the one group to a column in the adjacent group.

5. The integrated circuit of claim 1, wherein:

   each group includes a plurality of first wells of a first conductivity type, each first well extending in the column direction and including at least one transistor from memory cells of no more than two adjacent columns.

6. The integrated circuit of claim 1, wherein:

   the memory cells have a pitch in the row direction;
   the biasing network includes at least one conductive line disposed within the pitch; and
   each source switch comprises a plurality of switch cells, each switch cell fitting within the pitch of its corresponding group, each switch cell providing its own controllable impedance path between the at least one bias voltage and the corresponding bias network.

7. An integrated circuit, comprising:

   a plurality of static random access memory (SRAM) cells organized into multiple groups, each SRAM cell including a first transistor having a source;
   a source bias network corresponding to each group formed over a semiconductor substrate, each source bias network comprising
a plurality of first conductive lines arranged in a first direction and connected the sources of the corresponding group arranged in a first direction, and
at least one shorting line arranged in a second direction that conductively connects the first conductive lines of the network together.

8. The integrated circuit of claim 7, wherein:

each SRAM cell varies its current leakage in response to at least a first bias voltage applied to at least the source of its first transistor.

9. The integrated circuit of claim 7, further including:

each group includes a plurality of SRAM cell rows, each row being accessed in response to the activation of a corresponding word line; and
a decoder comprising
a predecode section that generates pre-decoded signals from a received memory address,
a word line decoder section that selectively activates at least one word line in response to the applied memory address, and
a switch decoder section that selectively applies one of at least two bias voltages to the source bias network corresponding to the group containing the at least one activated word line.

10. The integrated circuit of claim 7, further including:

each SRAM cell further varies current leakage in response to at least a first body bias voltage applied to a body of at least one transistor of the SRAM cell;
a body bias switch circuit corresponding to each group that applies at least a first body bias voltage to the bodies of the one transistors of its corresponding group in response to an activation of a corresponding body bias signal; and
a decoder that activates less than all body bias signals in response to an applied memory address, and de-activates the body bias select signals in a default mode.

11. The integrated circuit of claim 7, further including:

a plurality of bit lines coupled to the memory cells of at least two groups; and
the first conductive lines are formed from a same metallization layer as the bit lines, and the at least one shorting line is formed from a different metallization layer than the bit lines.

12. An integrated circuit, comprising:

at least one memory cell array comprising a plurality of memory cells arranged into rows and columns, each memory cell including at least a first transistor with a source connected one of a plurality of source bias lines formed over a semiconductor substrate in the column direction; and
at least one source switching circuit that selectively drives the source bias lines between at least two different bias voltages in response to the memory cell array being accessed.

13. The integrated circuit of claim 12, wherein:

the at least one source switching circuit comprises a plurality of switch elements, each switch element including a switch device coupled between the source bias lines and a first bias voltage.

14. The integrated circuit device of 13, wherein:

at least some of the switch elements are arranged generally in the row direction, substantially parallel to the rows of the memory array; and
at least others of the switch elements are arranged generally in the column direction, substantially parallel to the columns of the memory cell array.

**15.** The integrated circuit of claim 12, wherein:

the at least one source switching circuit includes
at least one switch that selectively couples the source lines to a first bias voltage in response to a select signal, and
at least one clamping device that prevents the source lines from varying outside of a predetermined voltage range.

FIG. 1A

FIG. 1B

FIG. 2

FIG. 3
(CONVENTIONAL)

FIG. 4

FIG. 5A

FIG. 5B

FIG. 6

FIG. 7

FIG. 8

800

GROUP 0
802-0

816-0

830

GROUP 1
802-1

816-1

BL    BLB

VVSS    VDD    VVSS
(Grp0)              (Grp0)

826

814-k2

814-k1
814-k0
830

814-l0
814-l1

814-l2

824-00
824-01

806-0
832
806-1

824-10
824-11

VVSS      VDD      VVSS
(Grp1) BL    BLB (Grp1)

FIG. 9

900

902-00

928-0
916-00
918
916-10
928-1

902-10

904-0

910-0

914
924
906-0
906-1
902-01

928-2
916-01
934
916-11
928-3

902-11

904-1

910-1

FIG. 10

WELL TAP CKT 1036-0

CELL GROUP 1002-0

SWITCH CKT 1016-0

SWITCH CKT 1016-1

CELL GROUP 1002-1

WELL TAP CKT 1036-1

1000

1040

1038 1038 -- 1038

1014 1014 -- 1014
1014 1014 -- 1014
1014 1014 -- 1014

1014 1014 -- 1014

1034 1034 -- 1034

1034 1034 -- 1034

1014 1014 -- 1014
1014 1014 -- 1014
1014 1014 -- 1014

1014 1014 -- 1014

1038 1038 -- 1038

COL. DIR.

ROW DIR.

1100

1124-0    1124-1

1114-0

N1    N2

1114-1

N1    N2

1128

Vbias2    1116    Vbias1

SSEL

FIG. 11

1200

SSEL

Vbias3    1216    Vbias4

1228

1214-0

P1    P2

1214-1

P1    P2

1224-0    1224-1

FIG. 12

FIG. 13B

FIG. 13C

FIG. 13A

FIG. 14

FIG. 15

FIG. 16

FIG. 17

FIG. 18

FIG. 19

FIG. 20

2100

GWL0
GWL1
GWLi

2102

WLDs
2174

SEL CKT 2176

2180

2178

SEL

FIG. 21A

2178'

GWL0
GWL1
GWLi

SELB

FIG. 21B

2200

GWL0
GWL1
GWLi
LDEC

2274

Local
WLD
2280

LWL00
LWL01
LWL0i

2202

Local
WLD
2280

LWL10
LWL11
LWL1i

2242

2280

Local
WLD
2280

LWLi0
LWLi1
LWLij

2282

VVSS
or VB

FIG. 22A

FIG. 22B

GWL0-i
LDEC

2200

2202-0

WLDs
2274-0

2278-0

SEL CKT 2276-0

SEL0

Grp_SEL0

Grp_SEL1

SEL1

2278-1

SEL CKT 2276-1

WLDs
2274-1

2202-1

| MODE | | Vcc | Vss | Config. 1 | | | | Config. 2 | | | |
|---|---|---|---|---|---|---|---|---|---|---|---|
| | | | | N-Ch | | P-Ch | | N-Ch | | P-Ch | |
| | | | | VBB | VbsN | VBB | VbsP | VBB | VbsN | VBB | VbsP |
| STBY | | 1.0 | 0.35 | 0.0 | -0.35 | 1.3 | -0.3 | 0.35 | 0.0 | 1.0 | 0.0 |
| ACTIVE | Selected Group | 1.0 | 0.0 | 0.0 | 0.0 | 1.3 | -0.3 | 0.35 | 0.35 | 1.0 | 0.0 |
| | Un-Selected Group | 1.0 | 0.35 | 0.0 | -0.35 | 1.3 | -0.3 | 0.35 | 0.0 | 1.0 | 0.0 |

FIG. 23

| MODE | | Config. 1 | | | | | | Config. 2 | | | | | |
|---|---|---|---|---|---|---|---|---|---|---|---|---|---|
| | | Vcc | Vss | N-Ch | | P-Ch | | Vcc | Vss | N-Ch | | P-Ch | |
| | | | | VBB | VbsN | VBB | VbsP | | | VBB | VbsN | VBB | VbsP |
| STBY | | 0.65 | 0.00 | 0.00 | 0.00 | 1.00 | -0.35 | 0.65 | 0.00 | 0.00 | 0.00 | 1.00 | -0.35 |
| ACTIVE | Selected Group | 0.85 | 0.00 | 0.35 | 0.35 | 1.00 | -0.15 | 1.00 | 0.00 | 0.35 | 0.35 | 1.00 | 0.00 |
| | Un-Selected Group | 0.65 | 0.00 | 0.00 | 0.00 | 1.00 | -0.35 | 0.65 | 0.00 | 0.00 | 0.00 | 1.00 | -0.35 |

FIG. 24

FIG. 25A

FIG. 25B

FIG. 25C

FIG. 26

FIG. 27

FIG. 28

FIG. 29

3000

3051                    NMOS              PMOS              3051

BBiasN
3053-N                                                              BBiasP
                                                                   3053-P

p                p                    n                    n

3084    p    3090-P    3084    3090-N    n    3084

n    3086-N              3086-P    p

3050                              p

FIG. 30

3100

3151

                    NMOS

3153-N                                        3163

                                              3157
                                              3159
p                                             3161

3184    p    3190-P

        n    3186-N    3184

3150

FIG. 31

FIG. 32A

3214

P1

N4

N1

Active

Gate

M1

Contact/
Via

N2

N3     3252-0
(Active)     3252-1
(Active)     P2     3252-0
(Active)     3250

FIG. 32B

3214

M2

Via

3242
WL

3250

FIG. 32C

3214     VVSS     BL     VDD     BL     VVSS

M3

Via

3224-0     3206-0     3232     3206-1     3224-1     3250

FIG. 33A

N7c

N7b

N7b'

N7c'

3334-0

SSEL

P3

N7a

3318-M1 VVSS

N7a'

P3'

3334-1

3352-0 (Active)

3352-1 (Active)

3352-0 (Active)

3350

Active

Gate

M1

Contact/ Via

FIG. 33B

M2

Via

3334-0

3318-M20

3328

3328'

3334-1

3318-M20'

VSS-M2

3318-M21 VVSS

VSS-M2'

3350

FIG. 33C

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2002/122329 A1 (MA LIN [US] ET AL) 5 September 2002 (2002-09-05) * paragraph [0023] - paragraph [0025]; figures 2, 3 * | 1-15 | INV. G11C11/417 |
| X | US 2006/133161 A1 (JACQUET FRANCOIS [FR] ET AL) 22 June 2006 (2006-06-22) * paragraph [0019] - paragraph [0049]; figures 1-3 * | 1-6, 12-15 | |
| Y | | 7-11 | |
| Y | US 2008/112203 A1 (KWON HYUK-JOON [KR]) 15 May 2008 (2008-05-15) * paragraph [0008] * * paragraph [0045] * | 7-11 | |

TECHNICAL FIELDS SEARCHED (IPC)

G11C

The present search report has been drawn up for all claims

| Place of search | Date of completion of the search | Examiner |
|---|---|---|
| Munich | 17 February 2011 | Harms, Juergen |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 10 19 2908

This annex lists the patent family members relating to the patent documents cited in the above-mentioned European search report.
The members are as contained in the European Patent Office EDP file on
The European Patent Office is in no way liable for these particulars which are merely given for the purpose of information.

17-02-2011

| Patent document cited in search report | Publication date | Patent family member(s) | Publication date |
|---|---|---|---|
| US 2002122329 A1 | 05-09-2002 | NONE | |
| US 2006133161 A1 | 22-06-2006 | FR 2878068 A1 | 19-05-2006 |
| US 2008112203 A1 | 15-05-2008 | NONE | |